# EUROPEAN PATENT APPLICATION

(11) **EP 4 443 486 A1**
(43) Date of publication of application: **09.10.2024**
(21) Application number: 23214546.6
(22) Date of filing: 06.12.2023
(51) Int. Cl.: H01L 21/8234, H01L 21/48, H01L 27/088, H01L 29/417

(54) **SEMICONDUCTOR DEVICE**

(30) Priority: 07.04.2023 KR 20230046151
(71) Applicant: Samsung Electronics Co., Ltd., Suwon-si, Gyeonggi-do 16677 (KR)
(72) Inventor: KIM, Beom Jin, 16677 Suwon-si, Gyeonggi-do (KR); KIM, Guk Hee, 16677 Suwon-si, Gyeonggi-do (KR); KIM, Young Woo, 16677 Suwon-si, Gyeonggi-do (KR); KIM, Jun Soo, 16677 Suwon-si, Gyeonggi-do (KR); NA, Sang Cheol, 16677 Suwon-si, Gyeonggi-do (KR); LEE, Kyoung Woo, 16677 Suwon-si, Gyeonggi-do (KR); LEE, Anthony Dongick, 16677 Suwon-si, Gyeonggi-do (KR); LEE, Min Seung, 16677 Suwon-si, Gyeonggi-do (KR); CHAE, Myeong Gyoon, 16677 Suwon-si, Gyeonggi-do (KR); HA, Seung Seok, 16677 Suwon-si, Gyeonggi-do (KR)
(74) Representative: Kuhnen & Wacker Patent- und Rechtsanwaltsbüro PartG mbB

(57) **Abstract**

A semiconductor device is provided. The semiconductor device includes a substrate, an active pattern extending in a first horizontal direction on an upper surface of the substrate, a field insulating layer surrounding a sidewall of the active pattern on the upper surface of the substrate, a first gate electrode extending in a second horizontal direction intersecting the first horizontal direction on the active pattern, a source/drain region disposed on at least one side of the first gate electrode on the active pattern, an upper interlayer insulating layer covering the source/drain region on the field insulating layer, a through via penetrating through the substrate, the field insulating layer and the upper interlayer insulating layer in a vertical direction, the through via spaced apart from the source/drain region in the second horizontal direction, a source/drain contact disposed inside the upper interlayer insulating layer on at least one side of the first gate electrode, the source/drain contact connected to the source/drain region, and a connection portion disposed inside the upper interlayer insulating layer, the connection portion connected to each of the through via and the source/drain contact, wherein a width of the connection portion in the first horizontal direction is greater than a width of the source/drain contact in the first horizontal direction.

## Description

### CROSS-REFERENCE TO RELATED APPLICATION

This application claims priority from Korean Patent Application No. 10-2023-0046151 filed on April 7, 2023 in the Korean Intellectual Property Office, the contents of which in its entirety are herein incorporated by reference.

### BACKGROUND

### 1. Technical Field

The present disclosure relates to a semiconductor device, and more particularly, to a semiconductor device including a multi-bridge channel field effect transistor (MBCFET^{™}).

### 2. Description of the Related Art

As one of the scaling techniques for increasing density of an integrated circuit device, a multi-gate transistor in which a fin-shaped or nanowire-shaped silicon body is formed on a substrate and a gate is formed on a surface of the silicon body has been proposed.

Since such a multi-gate transistor uses a three-dimensional channel, it is easy to perform scaling. In addition, it is possible to improve current control capability even without increasing a length of the gate of the multi-gate transistor. In addition, it is possible to effectively suppress a short channel effect (SCE) in which a potential of a channel region is affected by a drain voltage.

### SUMMARY

Aspects of the present disclosure provide a semiconductor device in which reliability of a connection between a source/drain contact and a through via is improved by using a connection portion.

According to an aspect of the disclosure, a semiconductor device includes: a substrate; an active pattern extending in a first horizontal direction on an upper surface of the substrate; a field insulating layer surrounding a sidewall of the active pattern on the upper surface of the substrate; a first gate electrode extending in a second horizontal direction intersecting the first horizontal direction on the active pattern; a source/drain region disposed on at least one side of the first gate electrode on the active pattern; an upper interlayer insulating layer covering the source/drain region on the field insulating layer; a through via penetrating through the substrate, the field insulating layer and the upper interlayer insulating layer in a vertical direction, the through via spaced apart from the source/drain region in the second horizontal direction; a source/drain contact disposed inside the upper interlayer insulating layer on at least one side of the first gate electrode, the source/drain contact connected to the source/drain region; and a connection portion disposed inside the upper interlayer insulating layer, the connection portion connected to each of the through via and the source/drain contact, wherein a width of the connection portion in the first horizontal direction is greater than a width of the source/drain contact in the first horizontal direction.

According to an aspect of the disclosure, a semiconductor device includes: a substrate; a first active pattern extending in a first horizontal direction on an upper surface of the substrate; a second active pattern extending in the first horizontal direction on the upper surface of the substrate, the second active pattern spaced apart from the first active pattern in a second horizontal direction intersecting the first horizontal direction; a first gate electrode extending in the second horizontal direction on the first active pattern; a second gate electrode extending in the second horizontal direction on the second active pattern, the second gate electrode spaced apart from the first gate electrode in the second horizontal direction; a source/drain region disposed on at least one side of the first gate electrode on the first active pattern; an upper interlayer insulating layer covering the source/drain region on the upper surface of the substrate; a gate cut extending in the first horizontal direction between the first active pattern and the second active pattern, the gate cut penetrating through the substrate and the upper interlayer insulating layer in a vertical direction and separating the first gate electrode and the second gate electrode from each other; a through via extending in the first horizontal direction inside the gate cut, the through via spaced apart from the source/drain region in the second horizontal direction; a source/drain contact disposed inside the upper interlayer insulating layer on at least one side of the first gate electrode, the source/drain contact connected to the source/drain region; and a connection portion disposed inside the upper interlayer insulating layer on at least one side of the first gate electrode, the connection portion connected to each of the through via and the source/drain contact, wherein a lower surface of the substrate, a lower surface of the gate cut, and a lower surface of the through via are each formed on a first plane.

According to an aspect of the disclosure, a semiconductor device includes: a substrate; a first active pattern extending in a first horizontal direction on an upper surface of the substrate; a second active pattern extending in the first horizontal direction on the upper surface of the substrate, the second active pattern spaced apart from the first active pattern in a second horizontal direction intersecting the first horizontal direction; a field insulating layer surrounding sidewalls of each of the first and second active patterns on the upper surface of the substrate; a first plurality of nanosheets stacked and spaced apart from each other in a vertical direction on the first active pattern; a second plurality of nanosheets stacked and spaced apart from each other in the vertical direction on the second active pattern; a first gate electrode extending in the second horizontal direction on the first active pattern, the first gate electrode surrounding the first plurality of nanosheets; a second gate electrode extending in the second horizontal direction on the second active pattern, the second gate electrode spaced apart from the first gate electrode in the second horizontal direction and surrounding the second plurality of nanosheets; a source/drain region disposed on at least one side of the first gate electrode on the first active pattern; an upper interlayer insulating layer covering the source/drain region on the field insulating layer; a gate cut extending in the first horizontal direction between the first active pattern and the second active pattern, the gate cut penetrating through the substrate, the field insulating layer, and the upper interlayer insulating layer in the vertical direction and separating the first gate electrode and the second gate electrode from each other; a through via extending in the first horizontal direction inside the gate cut, the through via spaced apart from the source/drain region in the second horizontal direction; a source/drain contact disposed inside the upper interlayer insulating layer on at least one side of the first gate electrode, the source/drain contact connected to the source/drain region and comprising a barrier layer forming sidewalls and a bottom surface of the source/drain contact and a filling layer filling a space between the sidewalls and the bottom surface formed by the barrier layer; a connection portion disposed inside the upper interlayer insulating layer on at least one side of the first gate electrode, the connection portion connected to each of the through via and the source/drain contact, formed as a single film, and in contact with each of the barrier layer and the filling layer; a lower interlayer insulating layer disposed on a lower surface of the substrate; and a lower wiring layer disposed inside the lower interlayer insulating layer, the lower wiring layer connected to the through via, wherein a width of the connection portion in the first horizontal direction is greater than a width of the source/drain contact in the first horizontal direction, and wherein the lower surface of the substrate, a lower surface of the gate cut, and a lower surface of the through via are each formed on a first plane.

However, aspects of the present disclosure are not restricted to those set forth herein. The above and other aspects of the present disclosure will become more apparent to one of ordinary skill in the art to which the present disclosure pertains by referencing the detailed description of the present disclosure given below.

### BRIEF DESCRIPTION OF THE DRAWINGS

The above and other aspects, features, and advantages of certain embodiments the present disclosure will become more apparent from the following description taken in conjunction with the accompanying drawings, in which:
FIG. 1 is a layout view for describing a semiconductor device according to one or more exemplary embodiments of the present disclosure;
FIG. 2 is a cross-sectional view taken along line A-A' of FIG. 1;
FIG. 3 is a cross-sectional view taken along line B-B' of FIG. 1;
FIG. 4 is a cross-sectional view taken along line C-C' of FIG. 1;
FIGS. 5 to 33 are intermediate step views for describing a method for fabricating a semiconductor device according to one or more exemplary embodiments of the present disclosure;
FIG. 34 is a cross-sectional view for describing a semiconductor device according to one or more exemplary embodiments of the present disclosure;
FIG. 35 is a cross-sectional view for describing a semiconductor device according to one or more exemplary embodiments;
FIG. 36 is a cross-sectional view for describing a semiconductor device according to one or more exemplary embodiments of the present disclosure;
FIG. 37 is a layout view for describing a semiconductor device according to one or more exemplary embodiments of the present disclosure;
FIG. 38 is a cross-sectional view taken along line D-D' of FIG. 37;
FIG. 39 is a cross-sectional view taken along line E-E' of FIG. 37; and
FIGS. 40 to 42 are cross-sectional views for describing a semiconductor device according to one or more exemplary embodiments of the present disclosure.

### DETAILED DESCRIPTION

In the drawings related to a semiconductor device according to one or more exemplary embodiments, it is exemplarily described that the semiconductor device includes a multi-bridge channel field effect transistor (MBCFET^{™}) including a nanosheet and a fin-type transistor (FinFET) including a channel region having a fin-type pattern shape, but the present disclosure is not limited thereto. In one or more exemplary embodiments, the semiconductor device may include a tunneling FET or a three-dimensional (3D) transistor. In addition, the semiconductor device according to one or more exemplary embodiments may also include a bipolar junction transistor, a lateral double-diffused metal oxide semiconductor (LDMOS) transistor, or the like.

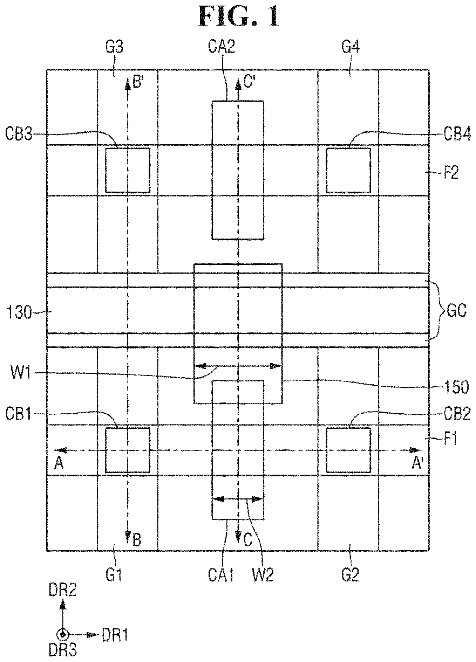

Hereinafter, a semiconductor device according to one or more exemplary embodiments of the present disclosure will be described with reference to FIGS. 1 to 4.

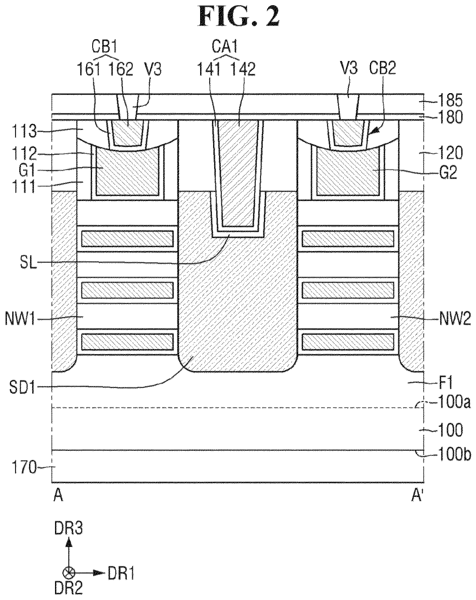

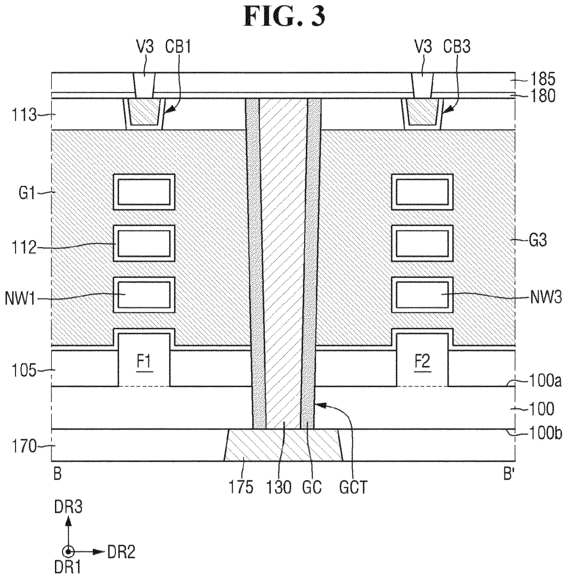

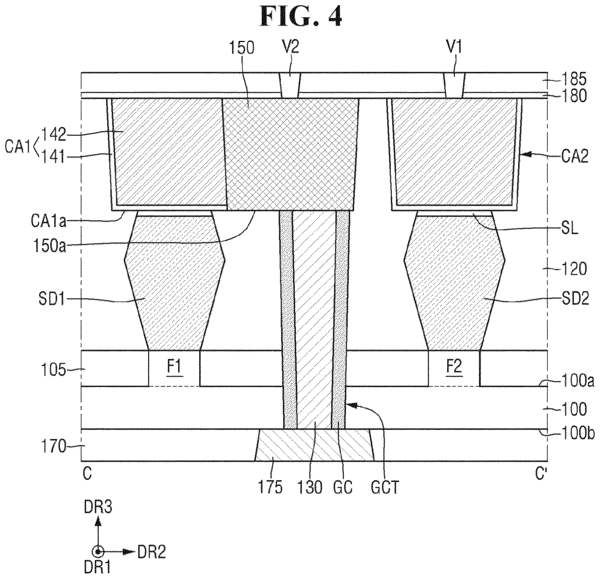

FIG. 1 is a layout view for describing a semiconductor device according to one or more exemplary embodiments of the present disclosure. FIG. 2 is a cross-sectional view taken along line A-A' of FIG. 1. FIG. 3 is a cross-sectional view taken along line B-B' of FIG. 1. FIG. 4 is a cross-sectional view taken along line C-C' of FIG. 1.

Referring to FIGS. 1 to 4, a semiconductor device according to one or more exemplary embodiments of the present disclosure may include a substrate 100, first and second active patterns F1 and F2, a field insulating layer 105, first to third plurality of nanosheets NW1, NW2, and NW3, first to fourth gate electrodes G1, G2, G3, and G4, a gate spacer 111, a gate insulating layer 112, a capping pattern 113, first and second source/drain regions SD1 and SD2, a first upper interlayer insulating layer 120, a gate cut GC, a through via 130, first and second source/drain contacts CA1 and CA2, a silicide layer SL, a connection portion 150, first to fourth gate contacts CB1, CB2, CB3, and CB4, a lower interlayer insulating layer 170, a lower wiring layer 175, an etch stop layer 180, a second upper interlayer insulating layer 185, and first to third vias V1, V2, and V3.

The substrate 100 may be a silicon substrate or silicon-on-insulator (SOI). Alternatively, the substrate 100 may include silicon germanium, silicon germanium on insulator (SGOI), indium antimonide, a lead tellurium compound, indium arsenide, indium phosphide, gallium arsenide, or gallium antimonide, but the present disclosure is not limited thereto.

Hereinafter, each of a first horizontal direction DR1 and a second horizontal direction DR2 may be defined as a direction parallel to an upper surface 100a of the substrate 100. A second horizontal direction DR2 may be defined as a direction different from the first horizontal direction DR1. A vertical direction DR3 may be defined as a direction perpendicular to each of the first horizontal direction DR1 and the second horizontal direction DR2. That is, the vertical direction DR3 may be defined as a direction perpendicular to the upper surface 100a of the substrate 100.

Each of the first and second active patterns F1 and F2 may extend in the first horizontal direction DR1 on the upper surface 100a of the substrate 100. The second active pattern F2 may be spaced apart from the first active pattern F1 in the second horizontal direction DR2. Each of the first and second active patterns F1 and F2 may protrude from the upper surface 100a of the substrate 100 in the vertical direction DR3. For example, each of the first and second active patterns F1 and F2 may also be a portion of the substrate 100, and may also include an epitaxial layer grown from the substrate 100.

The field insulating layer 105 may be disposed on the upper surface 100a of the substrate 100. The field insulating layer 105 may surround a sidewall of each of the first and second active patterns F1 and F2. For example, an upper surface of each of the first and second active patterns F1 and F2 may protrude more than an upper surface of the field insulating layer 105 in the vertical direction DR3. However, the present disclosure is not limited thereto. In one or more exemplary embodiments, the upper surface of each of the first and second active patterns F1 and F2 may be formed on the same plane as the upper surface of the field insulating layer 105. The field insulating layer 105 may include, for example, a silicon oxide film, a silicon nitride film, an oxynitride film, or a combination thereof.

The first plurality of nanosheets NW1 may be disposed on the first active pattern F1. The first plurality of nanosheets NW1 may be disposed at a portion where the first active pattern F1 and the first gate electrode G1 intersect. The second plurality of nanosheets NW2 may be disposed on the first active pattern F1. The second plurality of nanosheets NW2 may be disposed at a portion where the second active pattern F2 and the second gate electrode G2 intersect. The second plurality of nanosheets NW2 may be spaced apart from the first plurality of nanosheets NW1 in the first horizontal direction DR1. The third plurality of nanosheets NW3 may be disposed on the second active pattern F2. The third plurality of nanosheets NW3 may be disposed at a portion where the second active pattern F2 and the third gate electrode G3 intersect. The third plurality of nanosheets NW3 may be spaced apart from the first plurality of nanosheets NW1 in the second horizontal direction DR2.

Each of the first to third plurality of nanosheets NW1, NW2, and NW3 may include a plurality of nanosheets stacked to be spaced apart from each other in the vertical direction DR3. It is illustrated in FIGS. 2 and 3 that each of the first to third plurality of nanosheets NW1, NW2, and NW3 includes three nanosheets stacked to be spaced apart from each other in the vertical direction DR3, but this is for convenience of explanation, and the present disclosure is not limited thereto. In one or more exemplary embodiments, each of the first to third plurality of nanosheets NW1, NW2, and NW3 may include four or more nanosheets stacked to be spaced apart from each other in the vertical direction DR3.

For example, each of the first to third plurality of nanosheets NW1, NW2, and NW3 may include, for example, silicon (Si). However, the present disclosure is not limited thereto. In one or more exemplary embodiments, each of the first to third plurality of nanosheets NW1, NW2, and NW3 may include, for example, silicon germanium (SiGe).

The first gate electrode G1 may extend in the second horizontal direction DR2 on the first active pattern F1 and the field insulating layer 105. The first gate electrode G1 may surround the first plurality of nanosheets NW1. The second gate electrode G2 may extend in the second horizontal direction DR2 on the first active pattern F1 and the field insulating layer 105. The second gate electrode G2 may be spaced apart from the first gate electrode G1 in the first horizontal direction DR1. The second gate electrode G2 may surround the second plurality of nanosheets NW2.

The third gate electrode G3 may extend in the second horizontal direction DR2 on the second active pattern F2 and the field insulating layer 105. The third gate electrode G3 may be spaced apart from the first gate electrode G1 in the second horizontal direction DR2. The third gate electrode G3 may surround the third plurality of nanosheets NW3. The fourth gate electrode G4 may extend in the second horizontal direction DR2 on the second active pattern F2 and the field insulating layer 105. The fourth gate electrode G4 may be spaced apart from the third gate electrode G3 in the first horizontal direction DR1. The fourth gate electrode G4 may be spaced apart from the second gate electrode G2 in the second horizontal direction DR2. A fourth plurality of nanosheets may be disposed in a region where the fourth gate electrode G4 and the second active pattern F2 intersect.

Each of the first to fourth gate electrodes G1, G2, G3, and G4 may include, for example, at least one of titanium nitride (TiN), tantalum carbide (TaC), tantalum nitride (TaN), titanium silicon nitride (TiSiN), tantalum silicon nitride (TaSiN), tantalum titanium nitride (TaTiN), titanium aluminum nitride (TiAlN), tantalum aluminum nitride (TaAlN), tungsten nitride (WN), ruthenium (Ru), titanium aluminum (TiAl), titanium aluminum carbonitride (TiAlC-N), titanium aluminum carbide (TiAlC), titanium carbide (TiC), tantalum carbonitride (TaCN), tungsten (W), aluminum (Al), copper (Cu), cobalt (Co), titanium (Ti), tantalum (Ta), nickel (Ni), platinum (Pt), nickel platinum (Ni-Pt), niobium (Nb), niobium nitride (NbN), niobium carbide (NbC), molybdenum (Mo), molybdenum nitride (MoN), molybdenum carbide (MoC), tungsten carbide (WC), rhodium (Rh), palladium (Pd), iridium (Ir), osmium (Os), silver (Ag), gold (Au), zinc (Zn), vanadium (V), and a combination thereof. Each of the first to fourth gate electrodes G1, G2, G3, and G4 may include conductive metal oxide, conductive metal oxynitride, or the like, and may also include an oxidized form of the above-described material.

The gate spacer 111 may extend in the second horizontal direction DR2 along both sidewalls of the first gate electrode G1 on an upper surface of the uppermost nanosheet of the first plurality of nanosheets NW1 and the field insulating layer 105. The gate spacer 111 may extend in the second horizontal direction DR2 along both sidewalls of the second gate electrode G2 on an upper surface of the uppermost nanosheet of the second plurality of nanosheets NW2 and the field insulating layer 105. The gate spacer 111 may extend in the second horizontal direction DR2 along both sidewalls of the third gate electrode G3 on an upper surface of the uppermost nanosheet of the third plurality of nanosheets NW3 and the field insulating layer 105. The gate spacer 111 may extend in the second horizontal direction DR2 along both sidewalls of the fourth gate electrode G4 on the field insulating layer 105.

The gate spacer 111 may include, for example, at least one of silicon nitride (SiN), silicon oxynitride (SiON), silicon oxide (SiO₂), silicon oxycarbonitride (SiOCN), silicon boron nitride (SiBN), silicon oxyboron nitride (SiOBN), silicon oxycarbide (SiOC), and a combination thereof. However, the present disclosure is not limited thereto.

The gate insulating layer 112 may be disposed between each of the first to fourth gate electrodes G1, G2, G3, and G4 and the gate spacer 111. The gate insulating layer 112 may be disposed on a sidewall of each of the first to fourth gate electrodes G1, G2, G3, and G4 in the first horizontal direction DR1. The gate insulating layer 112 may be disposed between each of the first to fourth gate electrodes G1, G2, G3, and G4 and each of the first and second active patterns F1 and F2. The gate insulating layer 112 may be disposed between each of the first to fourth gate electrodes G1, G2, G3, and G4 and the field insulating layer 105. The gate insulating layer 112 may be disposed between the first gate electrode G1 and the first plurality of nanosheets NW1. The gate insulating layer 112 may be disposed between the second gate electrode G2 and the second plurality of nanosheets NW2. The gate insulating layer 112 may be disposed between the third gate electrode G3 and the third plurality of nanosheets NW3. The gate insulating layer 112 may be disposed between the fourth gate electrode G4 and a fourth plurality of nanosheets.

The gate insulating layer 112 may include at least one of silicon oxide, silicon oxynitride, silicon nitride, or a high-k material having a dielectric constant greater than that of the silicon oxide. The high-k material may include, for example, one or more of hafnium oxide, hafnium silicon oxide, hafnium aluminum oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, lead scandium tantalum oxide, or lead zinc niobate.

The semiconductor device according to one or more exemplary embodiments may include a negative capacitance (NC) field effect transistor (FET) using a negative capacitor. For example, the gate insulating layer 112 may include a ferroelectric material film having ferroelectric characteristics and a paraelectric material film having paraelectric characteristics.

The ferroelectric material film may have a negative capacitance, and the paraelectric material film may have a positive capacitance. For example, when two or more capacitors are connected in series with each other and the capacitance of each capacitor has a positive value, a total capacitance decreases as compared with a capacitance of each individual capacitor. On the other hand, when at least one of the capacitances of two or more capacitors connected in series with each other has a negative value, the total capacitance may be greater than an absolute value of each individual capacitance while having a positive value.

When the ferroelectric material film having the negative capacitance and the paraelectric material film having the positive capacitance are connected in series with each other, a total capacitance value of the ferroelectric material film and the paraelectric material film connected in series with each other may increase. A transistor including the ferroelectric material film may have a subthreshold swing (SS) less than 60 mV/decade at room temperature, using the increase in the total capacitance value.

The ferroelectric material film may have ferroelectric characteristics. The ferroelectric material film may include, for example, at least one of hafnium oxide, hafnium zirconium oxide, barium strontium titanium oxide, barium titanium oxide, and lead zirconium titanium oxide. Here, as an example, the hafnium zirconium oxide may be a material obtained by doping hafnium oxide with zirconium (Zr). As another example, the hafnium zirconium oxide may also be a compound of hafnium (Hf), zirconium (Zr), and oxygen (O).

The ferroelectric material film may further include a dopant. For example, the dopant may include at least one of aluminum (Al), titanium (Ti), niobium (Nb), lanthanum (La), yttrium (Y), magnesium (Mg), silicon (Si), calcium (Ca), cerium (Ce), dysprosium (Dy), erbium (Er), gadolinium (Gd), germanium (Ge), scandium (Sc), strontium (Sr), and tin (Sn). A type of dopant included in the ferroelectric material film may vary depending on a type of ferroelectric material included in the ferroelectric material film.

When the ferroelectric material film includes hafnium oxide, the dopant included in the ferroelectric material film may include, for example, at least one of gadolinium (Gd), silicon (Si), zirconium (Zr), aluminum (Al), and yttrium (Y).

When the dopant is aluminum (Al), the ferroelectric material film may include 3 to 8 atomic % (at%) of aluminum. Here, a ratio of the dopant may be a ratio of aluminum to the sum of hafnium and aluminum.

When the dopant is silicon (Si), the ferroelectric material film may include 2 to 10 at% of silicon. When the dopant is yttrium (Y), the ferroelectric material film may include 2 to 10 at% of yttrium. When the dopant is gadolinium (Gd), the ferroelectric material film may contain 1 to 7 at% of gadolinium. When the dopant is zirconium (Zr), the ferroelectric material film may include 50 to 80 at% of zirconium.

The paraelectric material film may have paraelectric characteristics. The paraelectric material film may include, for example, at least one of silicon oxide and metal oxide having a high dielectric constant. The metal oxide included in the paraelectric material film may include, for example, at least one of hafnium oxide, zirconium oxide, and aluminum oxide, but is not limited thereto.

The ferroelectric material film and the paraelectric material film may include the same material. The ferroelectric material film may have ferroelectric characteristics, but the paraelectric material film may not have ferroelectric characteristics. For example, when the ferroelectric material film and the paraelectric material film include hafnium oxide, a crystal structure of hafnium oxide included in the ferroelectric material film is different from a crystal structure of hafnium oxide included in the paraelectric material film.

The ferroelectric material film may have a thickness having ferroelectric characteristics. The thickness of the ferroelectric material film may be, for example, 0.5 to 10 nm, but is not limited thereto. Since a critical thickness representing ferroelectric characteristics may vary for each ferroelectric material, the thickness of the ferroelectric material film may vary depending on the ferroelectric material.

As an example, the gate insulating layer 112 may include one ferroelectric material film. As another example, the gate insulating layer 112 may include a plurality of ferroelectric material films spaced apart from each other. The gate insulating layer 112 may have a stacked layer structure in which a plurality of ferroelectric material films and a plurality of paraelectric material films are alternately stacked.

The capping pattern 113 may extend in the second horizontal direction DR2 on each of the first to fourth gate electrodes G1, G2, G3, and G4, the gate insulating layer 112, and the gate spacer 111. For example, the capping pattern 113 may be in contact with an upper surface of the gate spacer 111. However, the present disclosure is not limited thereto. In one or more exemplary embodiments, the capping pattern 113 may be disposed between the gate spacers 111. The capping pattern 113 may include, for example, at least one of silicon nitride (SiN), silicon oxynitride (SiON), silicon oxide (SiO₂), silicon carbonitride (SiCN), silicon oxycarbonitride (SiOCN), and a combination thereof. However, the present disclosure is not limited thereto.

The first source/drain region SD1 may be disposed on at least one side of each of the first gate electrode G1 and the second gate electrode G2 on the first active pattern F1. For example, the first source/drain region SD1 may be disposed on both sides of each of the first gate electrode G1 and the second gate electrode G2 on the first active pattern F1. The second source/drain region SD2 may be disposed on at least one side of each of the third gate electrode G3 and the fourth gate electrode G4 on the second active pattern F2. For example, the second source/drain region SD2 may be disposed on both sides of each of the third gate electrode G3 and the fourth gate electrode G4 on the second active pattern F2.

For example, the first source/drain region SD1 may be in contact with sidewalls of each of the first and second plurality of nanosheets NW1 and NW2 in the first horizontal direction DR1. The second source/drain region SD2 may be in contact with sidewalls of each of the third plurality of nanosheets NW3 and the fourth plurality of nanosheets in the first horizontal direction DR1. For example, each of the first source/drain region SD1 and the second source/drain region SD2 may be in contact with the gate insulating layer 112. However, the present disclosure is not limited thereto. In one or more exemplary embodiments, internal spacers may be disposed between each of the first source/drain region SD1 and the second source/drain region SD2 and the gate insulating layer 112. In this case, the internal spacer may include, for example, at least one of silicon nitride (SiN), silicon oxynitride (SiON), silicon oxide (SiO₂), silicon oxycarbonitride (SiOCN), silicon boron nitride (SiBN), silicon oxyboron nitride (SiOBN), silicon oxycarbide (SiOC), and a combination thereof.

The first upper interlayer insulating layer 120 may be disposed on the field insulating layer 105. Although FIG. 4 illustrates that the first upper interlayer insulating layer 120 is in contact with the upper surface of the field insulating layer 105, the present disclosure is not limited thereto. In one or more exemplary embodiments, an etch stop layer may be disposed between the upper surface of the field insulating layer 105 and the first upper interlayer insulating layer 120. The first upper interlayer insulating layer 120 may surround each of the first and second source/drain regions SD1 and SD2. The first upper interlayer insulating layer 120 may surround sidewalls of each of the gate spacer 111 and the capping pattern 113. For example, an upper surface of the first upper interlayer insulating layer 120 may be formed on the same plane as an upper surface of the capping pattern 113. However, the present disclosure is not limited thereto. In one or more exemplary embodiments, the first upper interlayer insulating layer 120 may cover the upper surface of the capping pattern 113.

The first upper interlayer insulating layer 120 may include, for example, at least one of silicon oxide, silicon nitride, silicon oxynitride, and a low-k material. The low-k material may include, for example, fluorinated tetraethylorthosilicate (FTEOS), hydrogen silsesquioxane (HSQ), bis-benzocyclobutene (BCB), tetramethylorthosilicate (TMOS), octamethylcyclotetrasiloxane (OMCTS), hexamethyldisiloxane (HMDS), trimethylsilyl borate (TMSB), diacetoxyditertiarybutoxysiloxane (DADBS), trimethylsilyl phosphate (TMSP), polytetrafluoroethylene (PTFE), tonen silazene (TOSZ), fluoride silicate glass (FSG), polyimide nanofoams such as polypropylene oxide, carbon doped silicon oxide (CDO), organo silicate glass (OSG), SiLK, amorphous fluorinated carbon, silica aerogels, silica xerogels, mesoporous silica, or a combination thereof, but the present disclosure is not limited thereto.

A gate cut trench GCT may extend in the first horizontal direction DR1 between the first active pattern F1 and the second active pattern F2. The gate cut trench GCT may extend in the first horizontal direction DR1 between the first plurality of nanosheets NW1 and the third plurality of nanosheets NW3. For example, the gate cut trench GCT may extend in the vertical direction DR3 from a lower surface 100b of the substrate 100 to the upper surface of the first upper interlayer insulating layer 120. That is, the gate cut trench GCT may penetrate through the substrate 100, the field insulating layer 105, and the first upper interlayer insulating layer 120 in the vertical direction DR3.

For example, a width of the gate cut trench GCT in the second horizontal direction DR2 may decrease as it is closer to the lower surface 100b of the substrate 100. For example, a bottom surface of the gate cut trench GCT may be formed on the same plane as the lower surface 100b of the substrate 100. The gate cut trench GCT may separate the first gate electrode G1 and the third gate electrode G3 from each other. In addition, the gate cut trench GCT may separate the second gate electrode G2 and the fourth gate electrode G4 from each other.

The gate cut GC may be disposed along sidewalls of the gate cut trench GCT. For example, the gate cut GC may extend in the first horizontal direction DR1 along both sidewalls of the gate cut trench GCT in the second horizontal direction DR2. The gate cut GC may extend in the first horizontal direction DR1 between the first active pattern F1 and the second active pattern F2. The gate cut GC may extend in the first horizontal direction DR1 between the first plurality of nanosheets NW1 and the third plurality of nanosheets NW3. Although it is illustrated in FIGS. 3 and 4 that the gate cut GC is conformally formed, the present disclosure is not limited thereto.

For example, the gate cut GC may extend in the vertical direction DR3 from the lower surface 100b of the substrate 100 to the upper surface of the first upper interlayer insulating layer 120. That is, the gate cut GC may penetrate through the substrate 100, the field insulating layer 105, and the first upper interlayer insulating layer 120 in the vertical direction DR3. For example, a lower surface of the gate cut GC may be formed on the same plane as the lower surface 100b of the substrate 100. For example, the uppermost surface of the gate cut GC may be formed on the same plane as the upper surface of the capping pattern 113. Alternatively, the uppermost surface of the gate cut GC may be formed on the same plane as the upper surface of the first upper interlayer insulating layer 120.

For example, sidewalls of the gate cut GC may be in contact with each of the first to fourth gate electrodes G1, G2, G3, and G4 and the gate insulating layer 112. However, the present disclosure is not limited thereto. In one or more exemplary embodiments, the gate insulating layer 112 may be disposed between the gate cut GC and each of the first to fourth gate electrodes G1, G2, G3, and G4. In this case, the gate cut GC may not be in contact with each of the first to fourth gate electrodes G1, G2, G3, and G4. For example, the sidewalls of the gate cut GC may be in contact with each of the substrate 100, the field insulating layer 105, the first upper interlayer insulating layer 120, and the capping pattern 113. For example, the gate cut GC may be spaced apart from each of the first active pattern F1, the second active pattern F2, the first plurality of nanosheets NW 1, the second plurality of nanosheets NW2, the third plurality of nanosheets NW3, the fourth plurality of nanosheets, the first source/drain region SD1, and the second source/drain region SD2 in the second horizontal direction DR2.

The gate cut GC may include an insulating material. The gate cut GC may include, for example, at least one of silicon nitride (SiN), silicon oxynitride (SiON), silicon oxide (SiO₂), silicon carbonitride (SiCN); silicon oxycarbonitride (SiOCN), silicon boron nitride (SiBN), silicon oxyboron nitride (SiOBN), silicon oxycarbide (SiOC), and a combination thereof.

The through via 130 may fill a space between the gate cuts GC in the gate cut trench GCT. For example, the through via 130 may extend in the first horizontal direction DR1. For example, at least a portion of the through via 130 may overlap each of the first gate electrode G1 and the third gate electrode G3 in the second horizontal direction DR2. In addition, at least a portion of the through via 130 may overlap each of the second gate electrode G2 and the fourth gate electrode G4 in the second horizontal direction DR2. However, the present disclosure is not limited thereto. In one or more exemplary embodiments, at least a portion of the through via 130 may not overlap each of the first to fourth gate electrodes G1, G2, G3, and G4 in the second horizontal direction DR2.

For example, the through via 130 may extend in the vertical direction DR3 from the lower surface 100b of the substrate 100 to the upper surface of the first upper interlayer insulating layer 120. That is, the through via 130 may penetrate through the substrate 100, the field insulating layer 105, and the first upper interlayer insulating layer 120 in the vertical direction DR3. For example, a lower surface of the through via 130 may be formed on the same plane as the lower surface 100b of the substrate 100. For example, the uppermost surface of the through via 130 may be formed on the same plane as the upper surface of the capping pattern 113 and the uppermost surface of the gate cut GC. Alternatively, the uppermost surface of the through via 130 may be formed on the same plane as the upper surface of the first upper interlayer insulating layer 120. For example, a sidewall of the through via 130 may be in contact with the gate cut GC.

For example, the through via 130 may be spaced apart from each of the first active pattern F1, the second active pattern F2, the first plurality of nanosheets NW1, the second plurality of nanosheets NW2, the third plurality of nanosheets NW3, the fourth plurality of nanosheets, the first source/drain region SD1, and the second source/drain region SD2 in the second horizontal direction DR2. The through via 130 may be insulated from each of the first to fourth gate electrodes G1, G2, G3, and G4 by the gate cut GC. In addition, the through via 130 may be insulated from the substrate 100 by the gate cut GC.

The through via 130 may include a conductive material. The through via 130 may include, for example, at least one of tantalum (Ta), tantalum nitride (TaN), titanium (Ti), titanium nitride (TiN), ruthenium (Ru), cobalt (Co), nickel (Ni), nickel boron (NiB), tungsten (W), tungsten nitride (WN), zirconium (Zr), zirconium nitride (ZrN), vanadium (V), vanadium nitride (VN), niobium (Nb), niobium nitride (NbN), platinum (Pt), iridium (Ir), rhodium (Rh), aluminum (Al), copper (Cu), and molybdenum (Mo).

The first source/drain contact CA1 may be disposed in the first upper interlayer insulating layer 120. The first source/drain contact CA1 may extend in the second horizontal direction DR2 between the first gate electrode G1 and the second gate electrode G2. For example, the through via 130 may be spaced apart from the first source/drain contact CA1 in the second horizontal direction DR2. The first source/drain contact CA1 may penetrate through the first upper interlayer insulating layer 120 in the vertical direction DR3 and be connected to the first source/drain region SD1.

The second source/drain contact CA2 may be disposed in the first upper interlayer insulating layer 120. The second source/drain contact CA2 may extend in the second horizontal direction DR2 between the third gate electrode G3 and the fourth gate electrode G4. For example, the second source/drain contact CA2 may be spaced apart from the through via 130 in the second horizontal direction DR2. The second source/drain contact CA2 may penetrate through the first upper interlayer insulating layer 120 in the vertical direction DR3 and be connected to the second source/drain region SD2.

For example, an upper surface of each of the first source/drain contact CA1 and the second source/drain contact CA2 may be formed on the same plane as the upper surface of the first upper interlayer insulating layer 120. For example, the upper surface of each of the first source/drain contact CA1 and the second source/drain contact CA2 may be formed on the same plane as each of the uppermost surface of the gate cut GC and the uppermost surface of the through via 130.

Each of the first source/drain contact CA1 and the second source/drain contact CA2 may include a first barrier layer 141 and a first filling layer 142. The first barrier layer 141 may form sidewalls and a bottom surface of the first source/drain contact CA1. The first filling layer 142 may fill a space between the first barrier layers 141 of the first source/drain contact CA1. In addition, the first barrier layer 141 may form sidewalls and a bottom surface of the second source/drain contact CA2. The first filling layer 142 may fill a space between the first barrier layers 141 of the second source/drain contact CA2.

The first barrier layer 141 may include, for example, at least one of tantalum (Ta), tantalum nitride (TaN), titanium (Ti), titanium nitride (TiN), ruthenium (Ru), cobalt (Co), nickel (Ni), nickel boron (NiB), tungsten (W), tungsten nitride (WN), zirconium (Zr), zirconium nitride (ZrN), vanadium (V), vanadium nitride (VN), niobium (Nb), niobium nitride (NbN), platinum (Pt), iridium (Ir), and rhodium (Rh). The first filling layer 142 may include, for example, at least one of aluminum (Al), copper (Cu), tungsten (W), cobalt (Co), ruthenium (Ru), and molybdenum (Mo).

The silicide layer SL may be disposed between the first source/drain contact CA1 and the first source/drain region SD1. In addition, the silicide layer SL may be disposed between the second source/drain contact CA2 and the second source/drain region SD2. The silicide layer SL may include, for example, a metal silicide material.

The connection portion 150 may be disposed in the first upper interlayer insulating layer 120. The connection portion 150 may extend in the second horizontal direction DR2 between the first gate electrode G1 and the second gate electrode G2. For example, the connection portion 150 may overlap each of the gate cut GC and the through via 130 in the first horizontal direction DR1. For example, the connection portion 150 may overlap each of the gate cut GC and the through via 130 in the vertical direction DR3.

The connection portion 150 may be connected to the first source/drain contact CA1. For example, the connection portion 150 may be in contact with each of the first barrier layer 141 and the first filling layer 142. The connection portion 150 may be connected to the through via 130. At least a portion of a lower surface 150a of the connection portion 150 may be in contact with each of the gate cut GC and the through via 130. Sidewalls of the connection portion 150 in the first horizontal direction DR1 may be in contact with each of the gate cut GC and the through via 130. For example, the second source/drain contact CA2 may be spaced apart from the connection portion 150 in the second horizontal direction DR2.

For example, an upper surface of the connection portion 150 may be formed on the same plane as each of the upper surface of the first source/drain contact CA1, the upper surface of the second source/drain contact CA2, the uppermost surface of the gate cut GC, and the uppermost surface of the through via 130. For example, a lower surface 150a of the connection portion 150 may be formed on the same plane as a lower surface CA1a of the first source/drain contact CA1. However, the present disclosure is not limited thereto. For example, a width W1 of the connection portion 150 in the first horizontal direction DR1 may be different from a width W2 of the first source/drain contact CA1 in the first horizontal direction DR1. For example, the width W1 of the connection portion 150 in the first horizontal direction DR1 may be greater than the width W2 of the first source/drain contact CA1 in the first horizontal direction DR1.

For example, the connection portion 150 may be formed as a single film. The connection portion 150 may include a conductive material. The connection portion 150 may include, for example, at least one of copper (Cu), carbon (C), silver (Ag), cobalt (Co), tantalum (Ta), indium (In), tin (Sn), zinc (Zn), manganese (Mn), titanium (Ti), chromium (Cr), germanium (Ge), strontium (Sr), platinum (Pt), magnesium (Mg), aluminum (Al), zirconium (Zr), tungsten (W), ruthenium (Ru), iridium (Ir), and rhodium (Rh). However, the present disclosure is not limited thereto. For example, in one or more exemplary embodiments, the connection portion 150 may include a material different from each of the first source/drain contact CA1 and the through via 130. In one or more exemplary embodiments, the connection portion 150 may include the same material as at least one of the first source/drain contact CA1 and the through via 130.

The first gate contact CB1 may penetrate through the capping pattern 113 in the vertical direction DR3 and be connected to the first gate electrode G1. The second gate contact CB2 may penetrate through the capping pattern 113 in the vertical direction DR3 and be connected to the second gate electrode G2. The third gate contact CB3 may penetrate through the capping pattern 113 in the vertical direction DR3 and be connected to the third gate electrode G3. The fourth gate contact CB4 may penetrate through the capping pattern 113 in the vertical direction DR3 and be connected to the fourth gate electrode G4.

For example, an upper surface of each of the first to fourth gate contacts CB1, CB2, CB3, and CB4 may be formed on the same plane as each of the upper surface of the capping pattern 113 and the upper surface of the first upper interlayer insulating layer 120. Each of the first to fourth gate contacts CB1, CB2, CB3, and CB4 may include a second barrier layer 161 and a second filling layer 162. The second barrier layer 161 may form sidewalls and a bottom surface of each of the first to fourth gate contacts CB1, CB2, CB3, and CB4. The second filling layer 162 may fill a space between the second barrier layers 161 in each of the first to fourth gate contacts CB1, CB2, CB3, and CB4.

The second barrier layer 161 may include, for example, at least one of tantalum (Ta), tantalum nitride (TaN), titanium (Ti), titanium nitride (TiN), ruthenium (Ru), cobalt (Co), nickel (Ni), nickel boron (NiB), tungsten (W), tungsten nitride (WN), zirconium (Zr), zirconium nitride (ZrN), vanadium (V), vanadium nitride (VN), niobium (Nb), niobium nitride (NbN), platinum (Pt), iridium (Ir), and rhodium (Rh). The second filling layer 162 may include, for example, at least one of aluminum (Al), copper (Cu), tungsten (W), cobalt (Co), ruthenium (Ru), and molybdenum (Mo).

The lower interlayer insulating layer 170 may be disposed on the lower surface 100b of the substrate 100. The lower interlayer insulating layer 170 may include, for example, at least one of silicon oxide, silicon nitride, silicon oxynitride, and a low-k material. The lower wiring layer 175 may be disposed inside the lower interlayer insulating layer 170. For example, the lower wiring layer 175 may extend in the first horizontal direction DR1. However, the present disclosure is not limited thereto. In one or more exemplary embodiments, the lower wiring layer 175 may also extend in the second horizontal direction DR2.

The lower wiring layer 175 may be connected to the through via 130. For example, the lower wiring layer 175 may be in contact with the lower surface of the through via 130, the lower surface of the gate cut GC, and the lower surface 100b of the substrate 100. The lower wiring layer 175 may include a conductive material. For example, the lower wiring layer 175 may include an insulating layer disposed on a portion in contact with the lower surface 100b of the substrate 100.

The etch stop layer 180 may be disposed on the upper surface of each of the first upper interlayer insulating layer 120, the capping pattern 113, the first to fourth gate contacts CB1, CB2, CB3, and CB4, the first and second source/drain contacts CA1 and CA2, the connection portion 150, the through via 130, and the gate cut GC. Although it is illustrated in FIGS. 2 to 4 that the etch stop layer 180 is formed as a single film, the present disclosure is not limited thereto. In one or more exemplary embodiments, the etch stop layer 180 may be formed as multiple films. The etch stop layer 180 may include, for example, at least one of aluminum oxide, aluminum nitride, hafnium oxide, zirconium oxide, silicon oxide, silicon nitride, silicon oxynitride, and a low-k material. The second upper interlayer insulating layer 185 may be disposed on the etch stop layer 180. The second upper interlayer insulating layer 185 may include, for example, at least one of silicon oxide, silicon nitride, silicon oxynitride, and a low-k material.

The first via V1 may penetrate through the second upper interlayer insulating layer 185 and the etch stop layer 180 in the vertical direction DR3 and be connected to the second source/drain contact CA2. The second via V2 may penetrate through the second upper interlayer insulating layer 185 and the etch stop layer 180 in the vertical direction DR3 and be connected to the connection portion 150. In one or more exemplary embodiments, the second via V2 may also penetrate through the second upper interlayer insulating layer 185 and the etch stop layer 180 in the vertical direction DR3 and be connected to the first source/drain contact CA1. The third via V3 may penetrate through the second upper interlayer insulating layer 185 and the etch stop layer 180 in the vertical direction DR3 and be connected to any one of the first to fourth gate contacts CB1, CB2, CB3, and CB4.

Although it is illustrated in FIGS. 2 to 4 that each of the first to third vias V1, V2, and V3 is formed as a single film, this is for convenience of explanation and the present disclosure is not limited thereto. That is, each of the first to third vias V1, V2, and V3 may be formed as multiple films. Each of the first to third vias V1, V2, and V3 may include a conductive material.

When the source/drain contact is directly connected to the through via, a connection failure may occur between the source/drain contact and the through via due to a difference in etching amount between the first upper interlayer insulating layer 120 and the gate cut GC. In the semiconductor device according to one or more exemplary embodiments of the present disclosure, a connection may be made between the first source/drain contact CA1 and the through via 130 using the connection portion 150. Accordingly, in the semiconductor device according to one or more exemplary embodiments of the present disclosure, reliability of the connection between the first source/drain contact CA1 and the through via 130 may be improved.

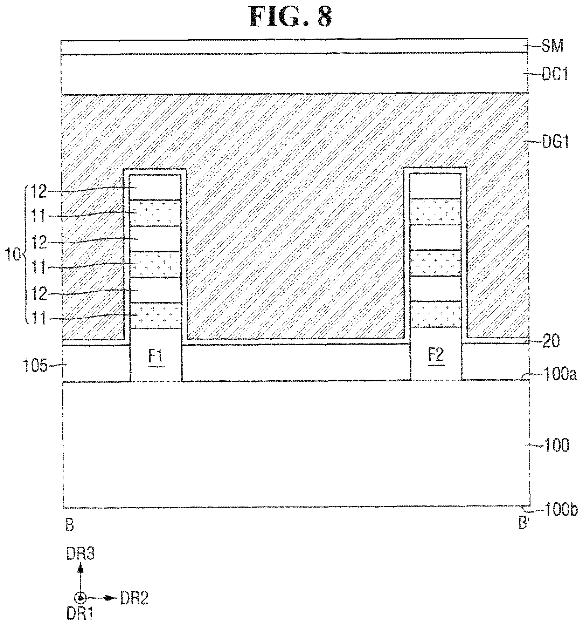

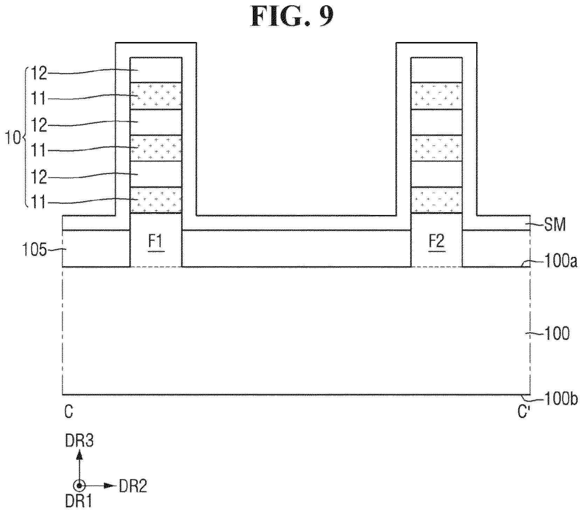

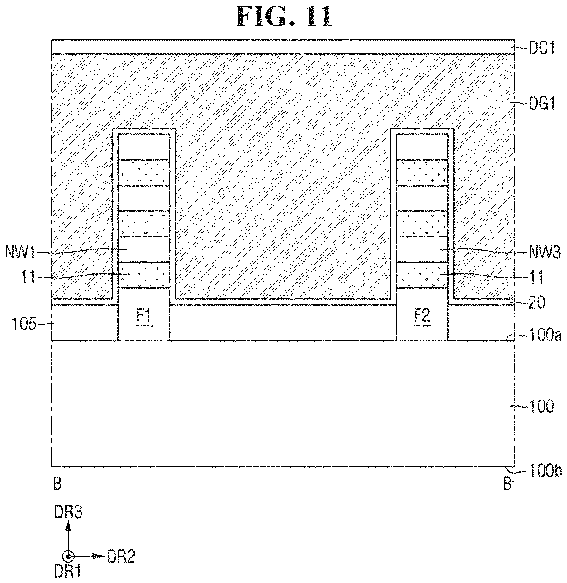

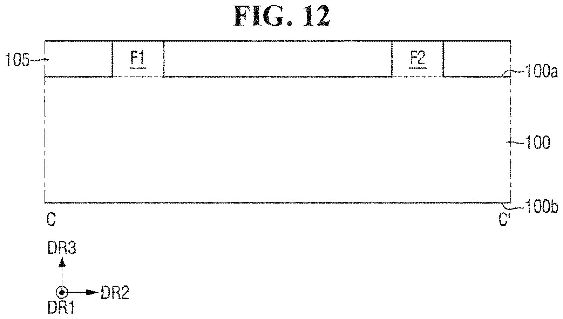

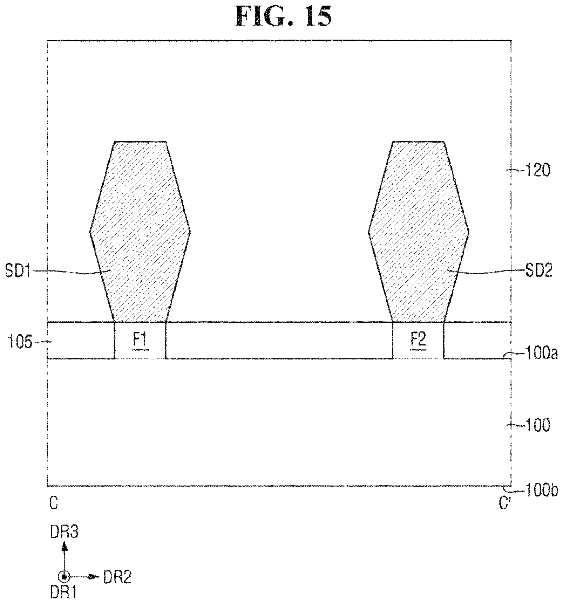

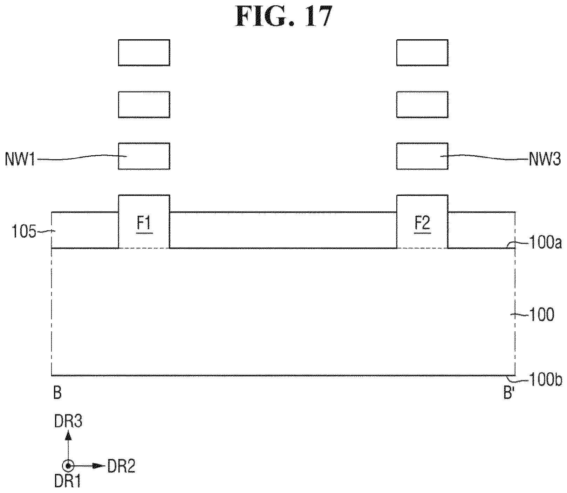

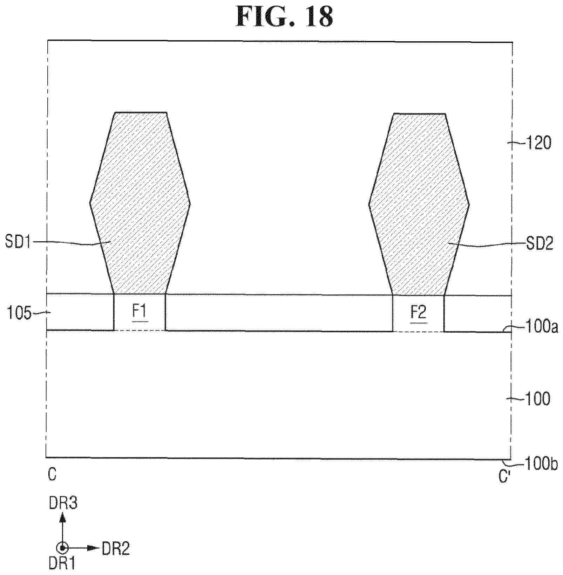

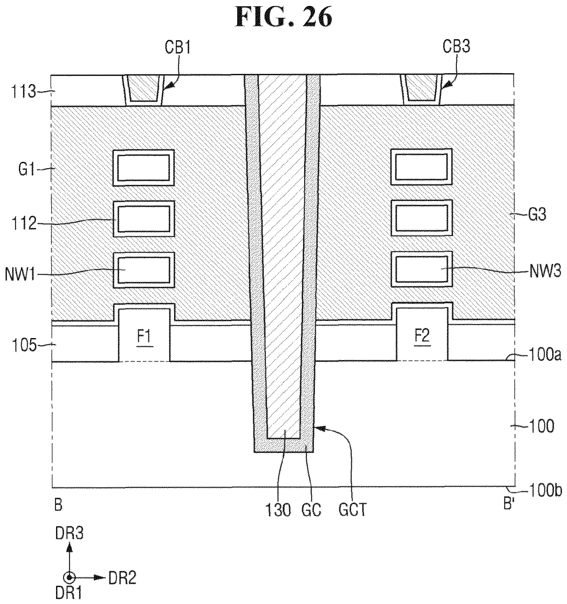

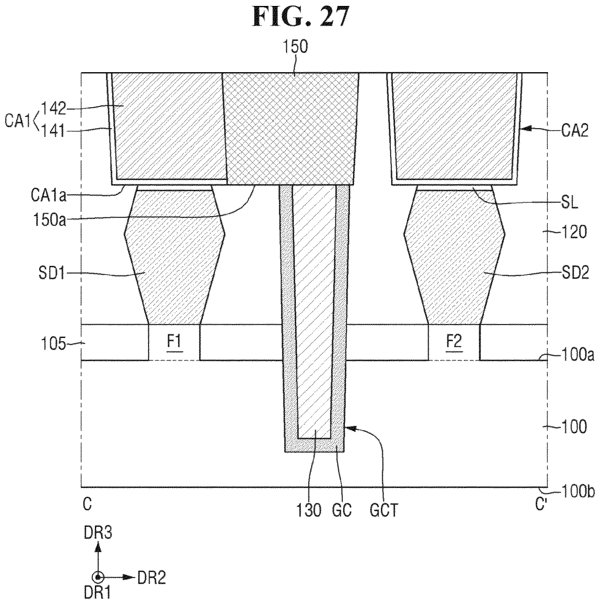

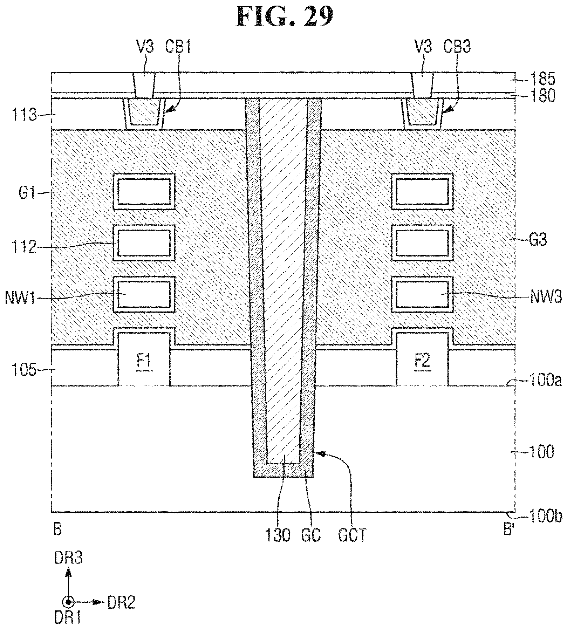

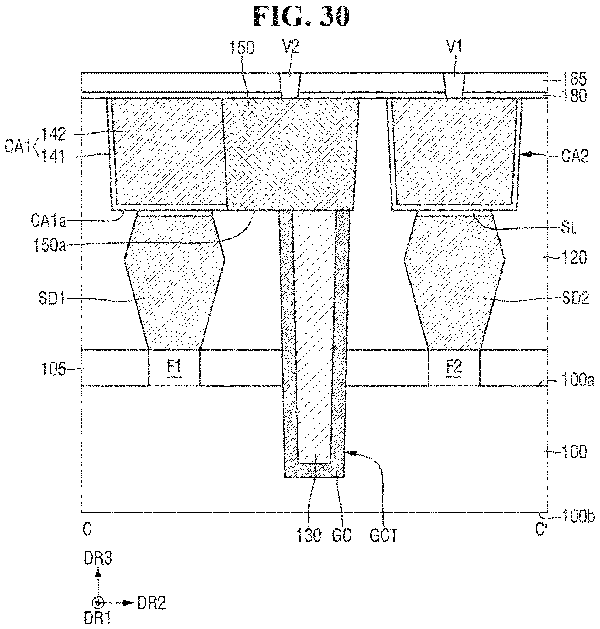

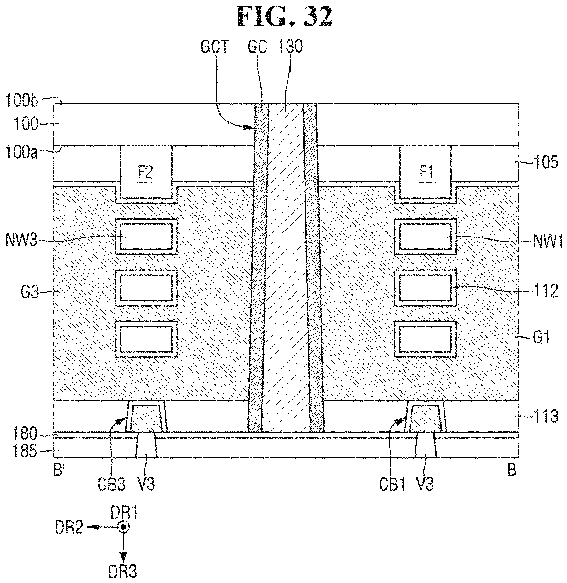

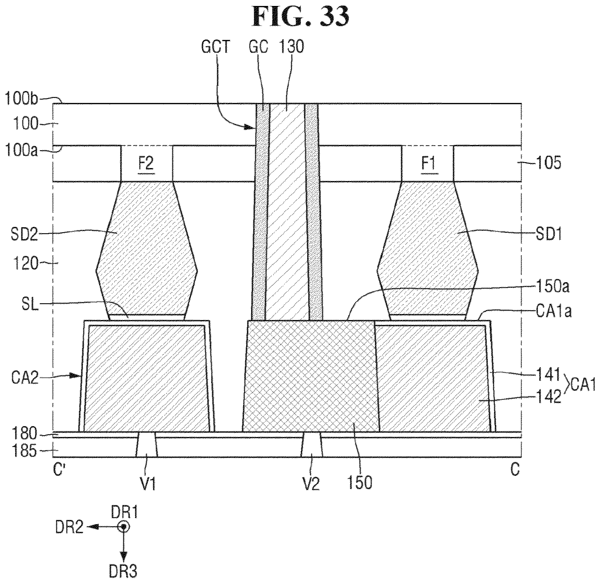

Hereinafter, a method of fabricating a semiconductor device according to one or more exemplary embodiments of the present disclosure will be described with reference to FIGS. 1 to 33.

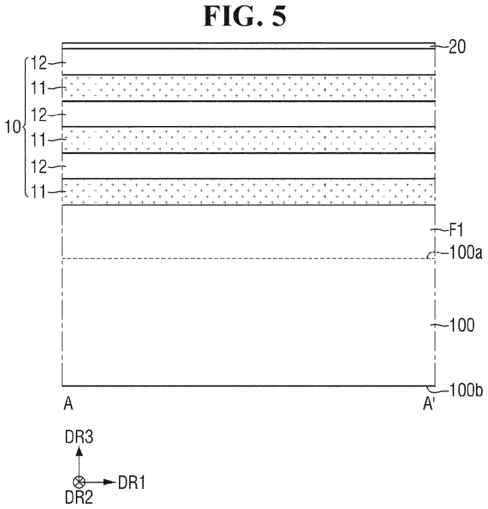

FIGS. 5 to 33 are intermediate step views for describing a method for fabricating a semiconductor device according to one or more exemplary embodiments of the present disclosure.

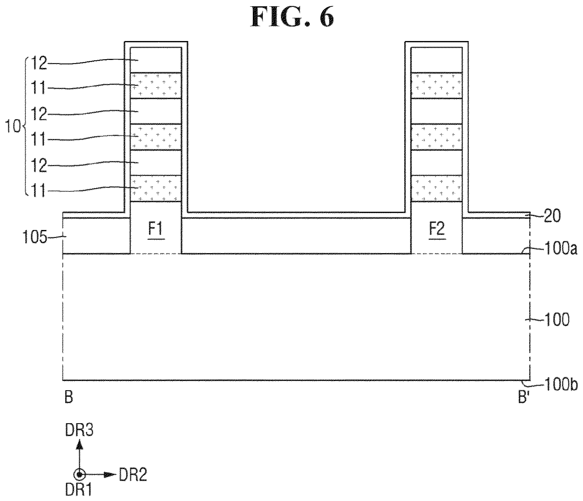

Referring to FIGS. 5 and 6, a stacked structure 10 may be formed on the substrate 100. The stacked structure 10 may include a first semiconductor layer 11 and a second semiconductor layer 12 alternately stacked on the substrate 100. For example, the first semiconductor layer 11 may be formed on the lowermost portion of the stacked structure 10, and the second semiconductor layer 12 may be formed on the uppermost portion of the stacked structure 10. However, the present disclosure is not limited thereto. In one or more exemplary embodiments, the first semiconductor layer 11 may also be formed on the uppermost portion of the stacked structure 10. The first semiconductor layer 11 may include, for example, silicon germanium (SiGe). The second semiconductor layer 12 may include, for example, silicon (Si).

Subsequently, a portion of the stacked structure 10 may be etched. While the stacked structure 10 is etched, a portion of the substrate 100 may also be etched. Through such an etching process, each of a first active pattern F1 and a second active pattern F2 may be defined on the upper surface 100a of the substrate 100 and on a lower side of the stacked structure 10. Each of the first active pattern F1 and the second active pattern F2 may extend in the first horizontal direction DR1. The second active pattern F2 may be spaced apart from the first active pattern F1 in the second horizontal direction DR2.

Subsequently, a field insulating layer 105 may be formed on the upper surface 100a of the substrate 100. The field insulating layer 105 may surround sidewalls of each of the first active pattern F1 and the second active pattern F2. For example, an upper surface of each of the first active pattern F1 and the second active pattern F2 may be formed to be higher than an upper surface of the field insulating layer 105. Subsequently, a pad oxide layer 20 may be formed to cover the upper surface of the field insulating layer 105, exposed sidewalls of each of the first active pattern F1 and the second active pattern F2, and sidewalls and an upper surface of the stacked structure 10. For example, the pad oxide layer 20 may be conformally formed. The pad oxide layer 20 may include, for example, silicon oxide (SiO₂).

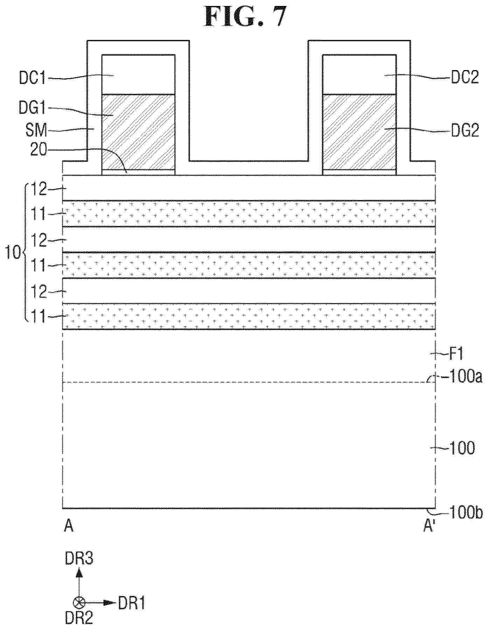

Referring to FIGS. 7 to 9, first and second dummy gates DG1 and DG2 and first and second dummy capping patterns DC1 and DC2 extending in the second horizontal direction DR2 may be formed on the pad oxide layer 20 on the stacked structure 10 and the field insulating layer 105. For example, the second dummy gate DG2 may be spaced apart from the first dummy gate DG1 in the first horizontal direction DR1. The first dummy capping pattern DC1 may be disposed on the first dummy gate DG1. The second dummy capping pattern DC2 may be disposed on the second dummy gate DG2. While the first and second dummy gates DG1 and DG2 and the first and second dummy capping patterns DC1 and DC2 are formed, the remaining pad oxide layer 20 except for a portion overlapping each of the first and second dummy gates DG1 and DG2 on the substrate 100 in the vertical direction DR3 may be removed.

Subsequently, a spacer material layer SM may be formed to cover sidewalls of each of the first and second dummy gates DG1 and DG2, sidewalls and an upper surface of each of the first and second dummy capping patterns DC1 and DC2, the exposed sidewalls and upper surface of the stacked structure 10, and an upper surface of the field insulating layer 105. For example, the spacer material layer SM may be conformally formed. The spacer material layer SM may include, for example, at least one of silicon nitride (SiN), silicon oxycarbonitride (SiOCN), silicon boron carbonitride (SiBCN), silicon carbonitride (SiCN), silicon oxynitride (SiON), and combinations thereof.

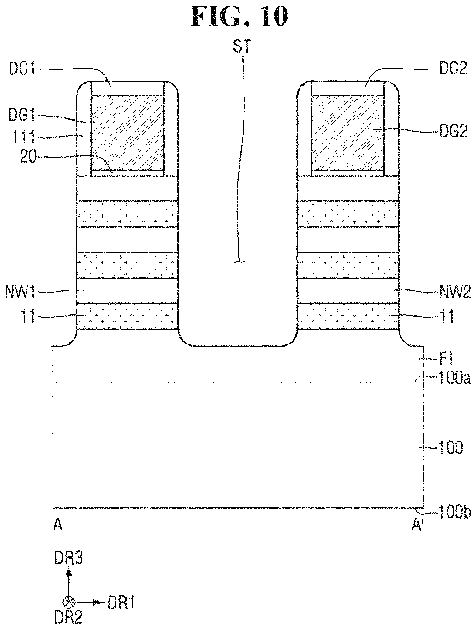

Referring to FIGS. 10 to 12, a source/drain trench ST may be formed by etching a stacked structure (10 in FIGS. 7 to 9) using the first and second dummy gates DG1 and DG2 and the first and second dummy capping patterns DC1 and DC2 as a mask. For example, the source/drain trench ST may extend into each of the first active pattern F1 and the second active pattern F2. While the source/drain trench ST is formed, the spacer material layer (SM in FIGS. 7 to 9) formed on the upper surface of each of the first and second dummy capping patterns DC1 and DC2 and a portion of each of the first and second dummy capping patterns DC1 and DC2 may be etched.

For example, the spacer material layer (SM in FIGS. 7 to 9) remaining on sidewalls of each of the first and second dummy capping patterns DC1 and DC2 and the first and second dummy gates DG1 and DG2 may be defined as a gate spacer 111. For example, after the source/drain trench ST is formed, the second semiconductor layer (12 in FIGS. 7 to 9) remaining on a lower side of the first dummy gate DG1 on the first active pattern F1 may be defined as a first plurality of nanosheets NW1. After the source/drain trench ST is formed, the second semiconductor layer (12 in FIGS. 7 to 9) remaining on a lower side of the second dummy gate DG2 on the first active pattern F1 may be defined as a second plurality of nanosheets NW2. After the source/drain trench ST is formed, the second semiconductor layer (12 in FIGS. 7 to 9) remaining on a lower side of the first dummy gate DG1 on the second active pattern F2 may be defined as a third plurality of nanosheets NW3.

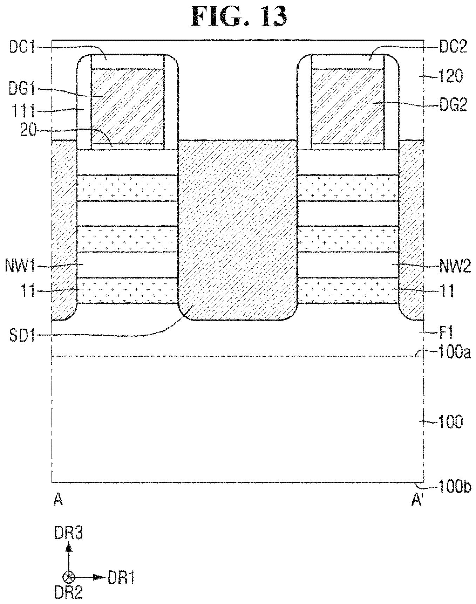

Referring to FIGS. 13 to 15, a first source/drain region SD1 may be formed inside the source/drain trench ST formed on the first active pattern F1. In addition, a second source/drain region SD2 may be formed inside the source/drain trench ST formed on the second active pattern F2. Subsequently, a first upper interlayer insulating layer 120 may be formed to cover sidewalls and upper surfaces of each of the first and second source/drain regions SD1 and SD2, the gate spacer 111, and the first and second dummy capping patterns DC1 and DC2, respectively.

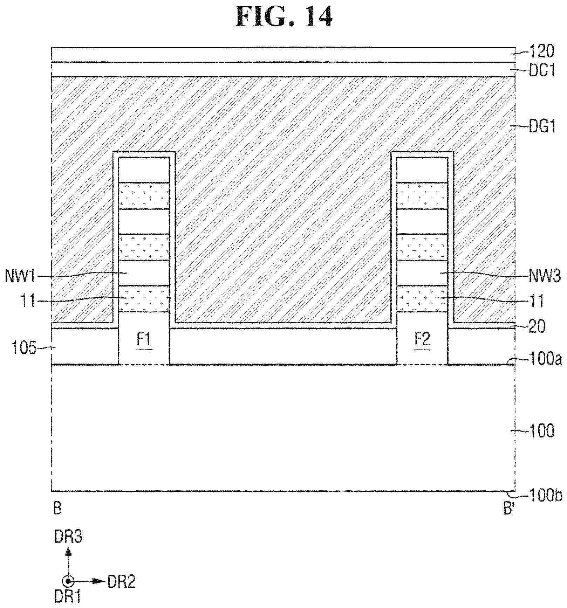

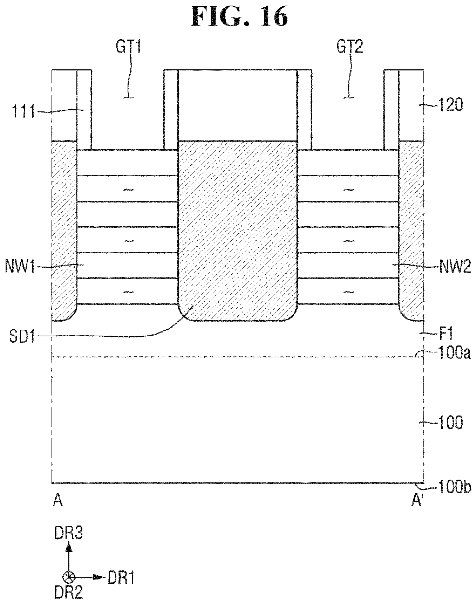

Referring to FIGS. 16 to 18, an upper surface of each of the first and second dummy gates (DG1 and DG2 in FIGS. 13 and 14) may be exposed through a planarization process. Subsequently, each of the first and second dummy gates (DG1 and DG2 in FIGS. 13 and 14), the pad oxide layer (20 in FIGS. 13 and 14), and the first semiconductor layer (11 in FIGS. 13 and 14) may be removed. A portion from which the first dummy gate (DG1 in FIGS. 13 and 14) is removed may be defined as a first gate trench GT1. A portion from which the second dummy gate (DG2 in FIG. 13) is removed may be defined as a second gate trench GT2.

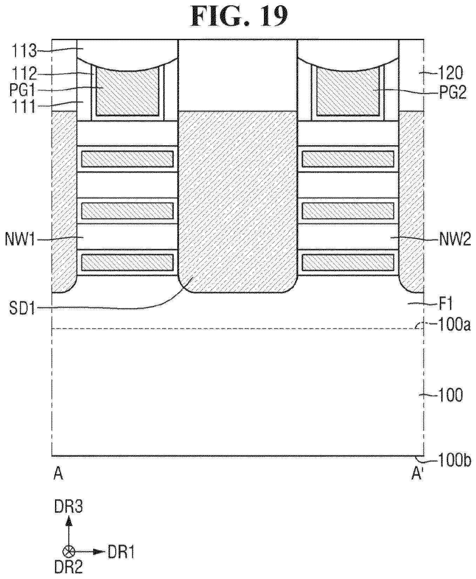

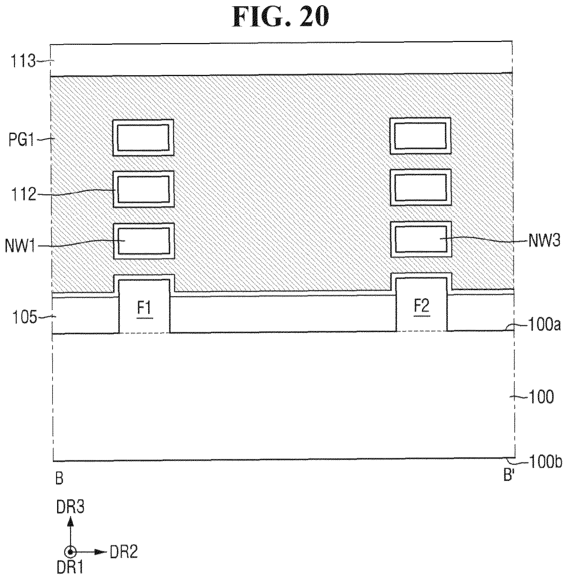

Referring to FIGS. 19 and 20, a gate insulating layer 112 and a first pre-gate electrode PG1 may be formed in a region where the first semiconductor layer 11 is removed from the inside of the first gate trench (GT1 in FIG. 16) and the lower side of the first plurality of nanosheets NW1. In addition, a gate insulating layer 112 and a second pre-gate electrode PG2 may be formed in a region where the first semiconductor layer 11 is removed from the inside of the second gate trench (GT2 in FIG. 16) and the lower side of the second plurality of nanosheets NW2. Subsequently, a capping pattern 113 may be formed on the gate spacer 111, the gate insulating layer 112, and the first pre-gate electrode PG1. In addition, the capping pattern 113 may be formed on the gate spacer 111, the gate insulating layer 112, and the second pre-gate electrode PG2.

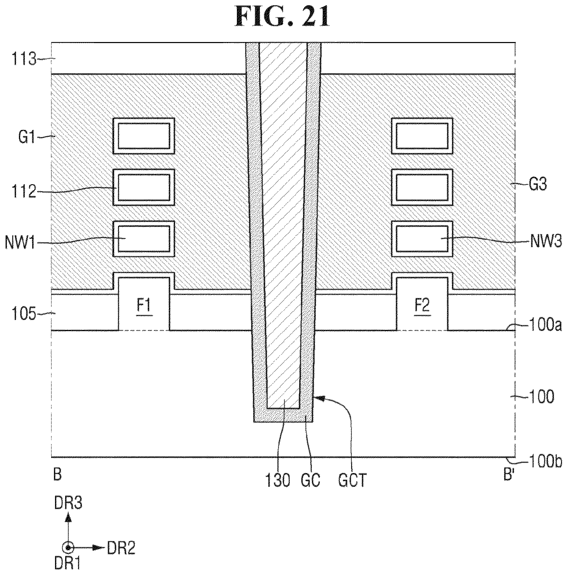

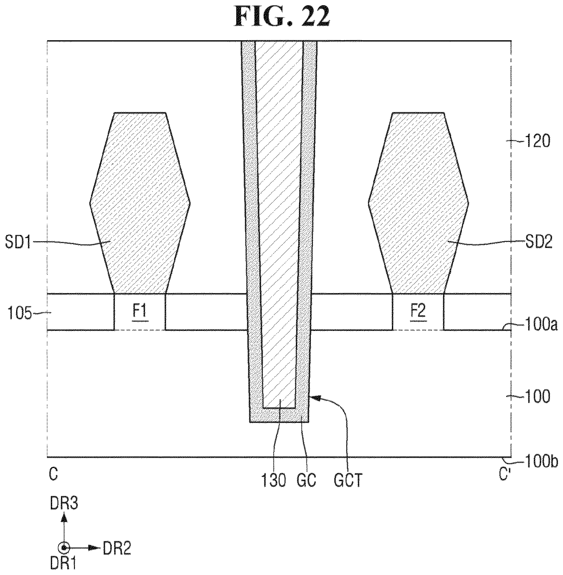

Referring to FIGS. 21 and 22, a gate cut trench GCT extending in the first horizontal direction DR1 may be formed between the first active pattern F1 and the second active pattern F2. The gate cut trench GCT may extend into the substrate 100 from each of the upper surface of the capping pattern 113 and the upper surface of the first upper interlayer insulating layer 120. That is, a bottom surface of the gate cut trench GCT may be formed inside the substrate 100. For example, the first pre-gate electrode (PG1 in FIGS. 19 and 20) may be separated into a first gate electrode G1 and a third gate electrode G3 by the gate cut trench GCT.

Subsequently, a gate cut GC may be formed along the sidewalls and bottom surface of the gate cut trench GCT. For example, the gate cut GC may be conformally formed. Subsequently, a through via 130 may be formed on the gate cut GC to fill the inside of the gate cut trench GCT.

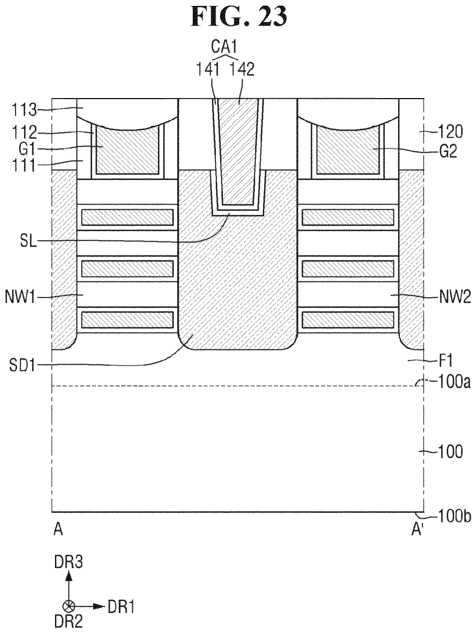

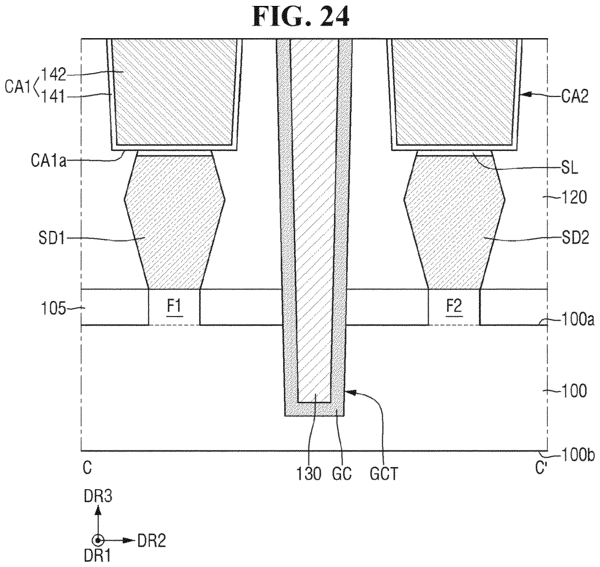

Referring to FIGS. 23 and 24, a first source/drain contact CA1 penetrating through the first upper interlayer insulating layer 120 in the vertical direction DR3 and connected to the first source/drain region SD1 may be formed. In addition, a second source/drain contact CA2 penetrating through the first upper interlayer insulating layer 120 in the vertical direction DR3 and connected to the second source/drain region SD2 may be formed. Each of the first source/drain contact CA1 and the second source/drain contact CA2 may be spaced apart from the gate cut GC in the second horizontal direction DR2.

For example, each of the first source/drain contact CA1 and the second source/drain contact CA2 may include a first barrier layer 141 and a first filling layer 142. In addition, a silicide layer SL may be formed between the first source/drain contact CA1 and the first source/drain region SD1 and between the second source/drain contact CA2 and the second source/drain region SD2.

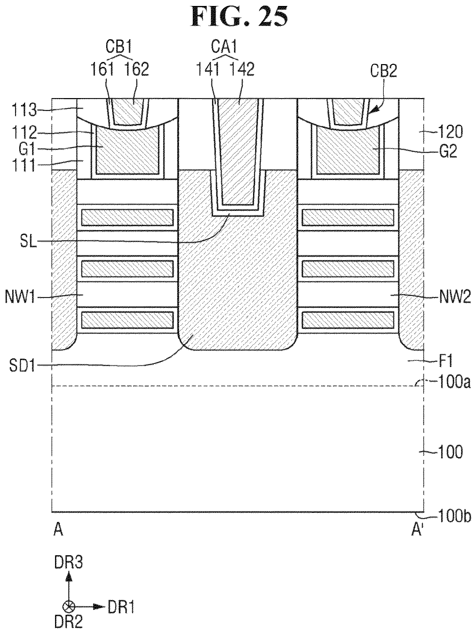

Referring to FIGS. 25 to 27, a portion of each of the first source/drain contact CA1, the first upper interlayer insulating layer 120, the gate cut GC, and the through via 130 may be etched. A connection portion 150 may be formed at a portion where a portion of each of the first source/drain contact CA1, the first upper interlayer insulating layer 120, the gate cut GC, and the through via 130 is etched. For example, the connection portion 150 may be formed as a single film. The connection portion 150 may be in contact with each of the first source/drain contact CA1, the gate cut GC, and the through via 130. The second source/drain contact CA2 may be spaced apart from the connection portion 150 in the second horizontal direction DR2.

In addition, each of the first to fourth gate contacts CB1, CB2, CB3, and CB4 penetrating through the capping pattern 113 in the vertical direction DR3 and connected to each of the first to fourth gate electrodes G1, G2, G3, and G4 may be formed. Each of the first to fourth gate contacts CB1, CB2, CB3, and CB4 may include a second barrier layer 161 and a second filling layer 162.

As an example, the connection portion 150 and the first to fourth gate contacts CB1, CB2, CB3, and CB4 may be formed at the same time.

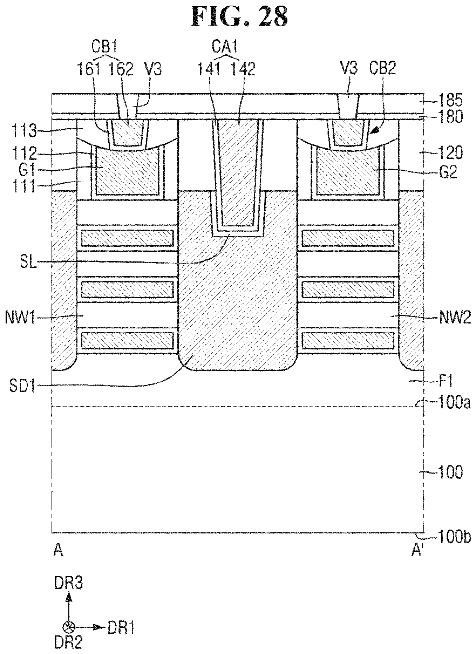

Referring to FIGS. 28 to 30, an etch stop layer 180 and a second upper interlayer insulating layer 185 may be sequentially formed on the upper surface of each of the first upper interlayer insulating layer 120, the capping pattern 113, the first to fourth gate contacts CB1, CB2, CB3, and CB4, the first and second source/drain contacts CA1 and CA2, the through via 130, and the gate cut GC.

Subsequently, a first via V1 penetrating through the second upper interlayer insulating layer 185 and the etch stop layer 180 in the vertical direction DR3 and connected to the second source/drain contact CA2 may be formed. In addition, a second via V2 penetrating through the second upper interlayer insulating layer 185 and the etch stop layer 180 in the vertical direction DR3 and connected to the connection portion 150 may be formed. In addition, a third via V3 penetrating through the second upper interlayer insulating layer 185 and the etch stop layer 180 in the vertical direction DR3 and connected to any one of the first to fourth gate contacts CB1, CB2, CB3, and CB4 may be formed.

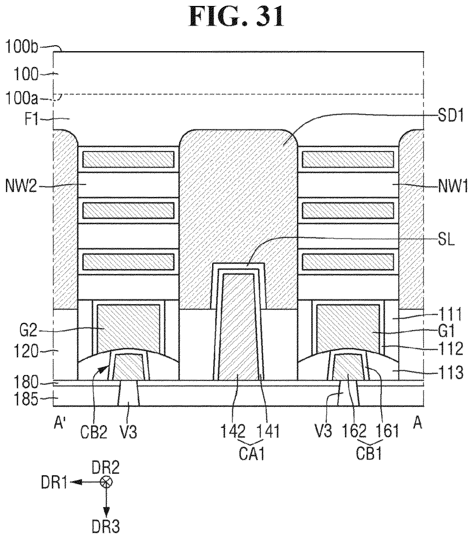

Referring to FIGS. 31 to 33, after the processes illustrated in FIGS. 28 to 30 are performed, the top and bottom may be reversed. Subsequently, the through via 130 may be exposed by etching a portion of the substrate 100 and a portion of the gate cut GC through a planarization process.

Referring to FIGS. 2 to 4, a lower interlayer insulating layer 170 may be formed on the lower surface 100b of the substrate 100, the exposed surface of the gate cut GC, and the exposed surface of the through via 130. Subsequently, a lower wiring layer 175 may be formed inside the lower interlayer insulating layer 170. The lower wiring layer 175 may be connected to the through via 130. For example, the lower wiring layer 175 may be in contact with each of the through via 130 and the gate cut GC. Subsequently, the semiconductor device illustrated in FIGS. 2 to 4 may be fabricated by reversing the top and bottom.

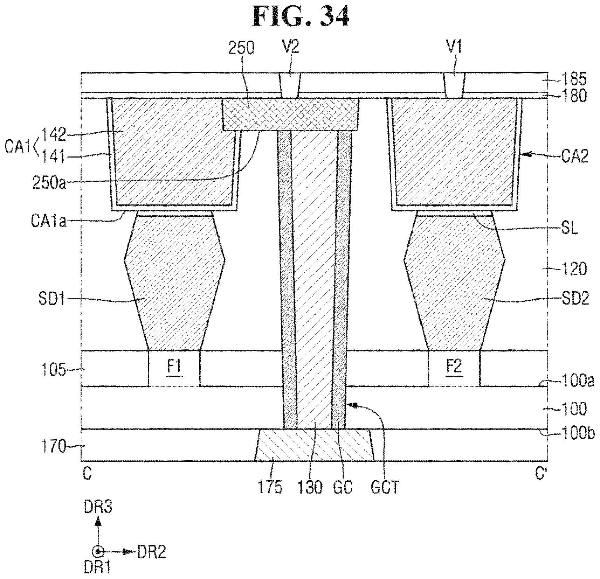

Hereinafter, a semiconductor device according to one or more exemplary embodiments of the present disclosure will be described with reference to FIG. 34. Differences from the semiconductor device illustrated in FIGS. 1 to 4 will be mainly described.

FIG. 34 is a cross-sectional view for describing a semiconductor device according to one or more exemplary embodiments of the present disclosure.

Referring to FIG. 34, in the semiconductor device according to one or more exemplary embodiments of the present disclosure, a lower surface 250a of a connection portion 250 may be formed to be higher than the lower surface CA1a of the first source/drain contact CA1.

For example, at least a portion of the connection portion 250 may extend into the first source/drain contact CA1. For example, at least a portion of the connection portion 250 may overlap the first source/drain contact CA1 in the vertical direction DR3. At least a portion of the lower surface 250a of the connection portion 250 may be in contact with each of the first barrier layer 141 and the first filling layer 142. One sidewall of the connection portion 250 in the second horizontal direction DR2 may be in contact with the first filling layer 142.

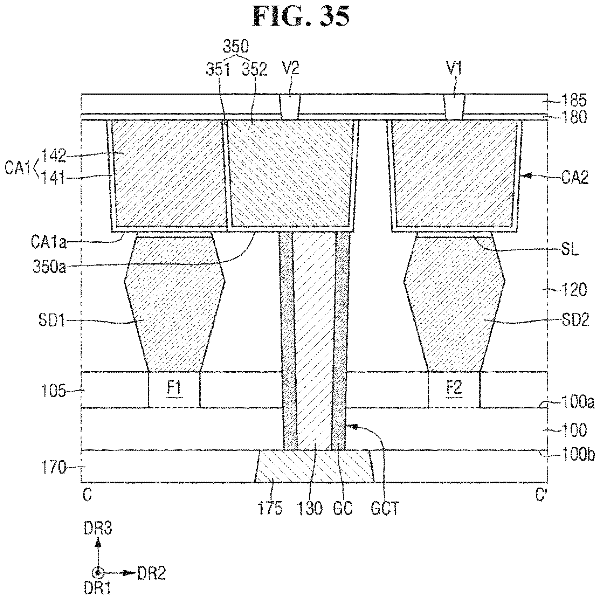

Hereinafter, a semiconductor device according to one or more exemplary embodiments of the present disclosure will be described with reference to FIG. 35. Differences from the semiconductor device illustrated in FIGS. 1 to 4 will be mainly described.

FIG. 35 is a cross-sectional view for describing a semiconductor device according to one or more exemplary embodiments.

Referring to FIG. 35, in the semiconductor device according to one or more exemplary embodiments of the present disclosure, a connection portion 350 may be formed as a double film.

For example, the connection portion 350 may include a connection portion barrier layer 351 and a connection portion filling layer 352. The connection portion barrier layer 351 may form sidewalls and a bottom surface of the connection portion 350. For example, the connection portion barrier layer 351 may be in contact with each of the first source/drain contact CA1, the through via 130, the gate cut GC, and the first upper interlayer insulating layer 120. For example, the connection portion barrier layer 351 may be in contact with each of the first barrier layer 141 and the first filling layer 142. As an example, at least a portion of side surfaces of the connection portion barrier layer 351 may be in contact with the first barrier layer 141 and the first filling layer 142 of the first source/drain contact CA1 in the second horizontal direction DR2. In addition, at least a portion of side surfaces of the connection portion barrier layer 351 may be in contact with the first upper interlayer insulating layer 120 in at least one of the first horizontal direction DR1 and the second horizontal direction DR2. As another example, the connection portion barrier layer 351 may be in contact with the through via 130 and the gate cut GC in the first horizontal direction DR1. In addition, the connection portion barrier layer 351 may be in contact with the first upper interlayer insulating layer 120, the through via 130, and the gate cut GC on a lower surface of the connection portion 350. The connection portion filling layer 352 may fill a space between the connection portion barrier layers 351. For example, the connection portion filling layer 352 is not in contact with each of the first source/drain contact CA1, the through via 130, the gate cut GC, and the first upper interlayer insulating layer 120. For example, the lower surface 350a of the connection portion 350 may be formed on the same plane as a lower surface CA1a of the first source/drain contact CA1.

The connection portion barrier layer 351 may include, for example, at least one of tantalum (Ta), tantalum nitride (TaN), titanium (Ti), titanium nitride (TiN), ruthenium (Ru), cobalt (Co), nickel (Ni), nickel boron (NiB), tungsten (W), tungsten nitride (WN), zirconium (Zr), zirconium nitride (ZrN), vanadium (V), vanadium nitride (VN), niobium (Nb), niobium nitride (NbN), platinum (Pt), iridium (Ir), and rhodium (Rh). The connection portion filling layer 352 may include, for example, at least one of aluminum (Al), copper (Cu), tungsten (W), cobalt (Co), ruthenium (Ru), and molybdenum (Mo).

For example, the connection portion barrier layer 351 may include the same material as the second barrier layer (161 in FIG. 2). In this case, the connection portion barrier layer 351 and the second barrier layer (161 in FIG. 2) may be formed through the same fabricating process. In addition, the connection portion filling layer 352 may include the same material as the second filling layer (162 in FIG. 2). In this case, the connection portion filling layer 352 and the second filling layer (162 in FIG. 2) may be formed through the same fabricating process. However, the present disclosure is not limited thereto. In one or more exemplary embodiments, the connection portion barrier layer 351 may also include a material different from that of the second barrier layer (161 in FIG. 2). In addition, the connection portion filling layer 352 may also include a material different from that of the second filling layer (162 in FIG. 2).

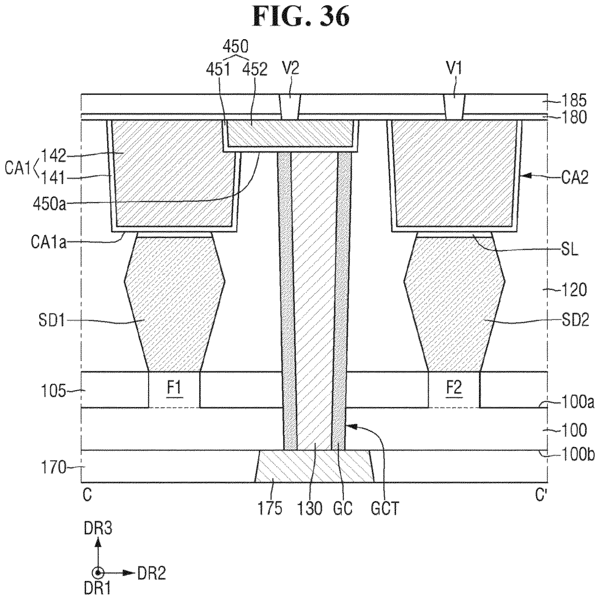

Hereinafter, a semiconductor device according to one or more exemplary embodiments of the present disclosure will be described with reference to FIG. 36. Differences from the semiconductor device illustrated in FIG. 35 will be mainly described.

FIG. 36 is a cross-sectional view for describing a semiconductor device according to one or more exemplary embodiments of the present disclosure.

Referring to FIG. 36, in the semiconductor device according to one or more exemplary embodiments of the present disclosure, a lower surface 450a of a connection portion 450 may be formed to be higher than the lower surface CA1a of the first source/drain contact CA1. In addition, the connection portion 450 may be formed as a double film.

For example, at least a portion of the connection portion 450 may extend into the first source/drain contact CA1. For example, at least a portion of the connection portion 450 may overlap the first source/drain contact CA1 in the vertical direction DR3. At least a portion of a lower surface 450a of the connection portion 450 may be in contact with each of the first barrier layer 141 and the first filling layer 142. One sidewall of the connection portion 450 in the second horizontal direction DR2 may be in contact with the first filling layer 142.

For example, the connection portion 450 may include a connection portion barrier layer 451 and a connection portion filling layer 452. The connection portion barrier layer 451 may form sidewalls and a bottom surface of the connection portion 450. For example, the connection portion barrier layer 451 may be in contact with each of the first source/drain contact CA1, the through via 130, the gate cut GC, and the first upper interlayer insulating layer 120. For example, the connection portion barrier layer 451 may be in contact with each of the first barrier layer 141 and the first filling layer 142. The connection portion filling layer 452 may fill a space between the connection portion barrier layers 451. For example, the connection portion filling layer 452 is not in contact with each of the first source/drain contact CA1, the through via 130, the gate cut GC, and the first upper interlayer insulating layer 120.

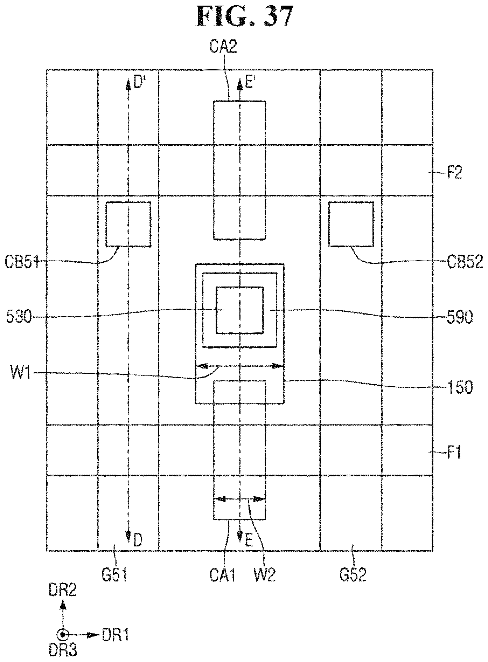

Hereinafter, a semiconductor device according to one or more exemplary embodiments of the present disclosure will be described with reference to FIGS. 37 to 39. Differences from the semiconductor device illustrated in FIGS. 1 to 4 will be mainly described.

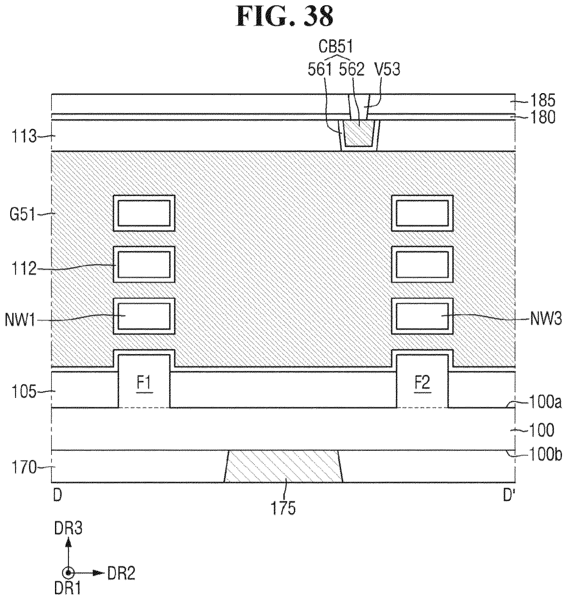

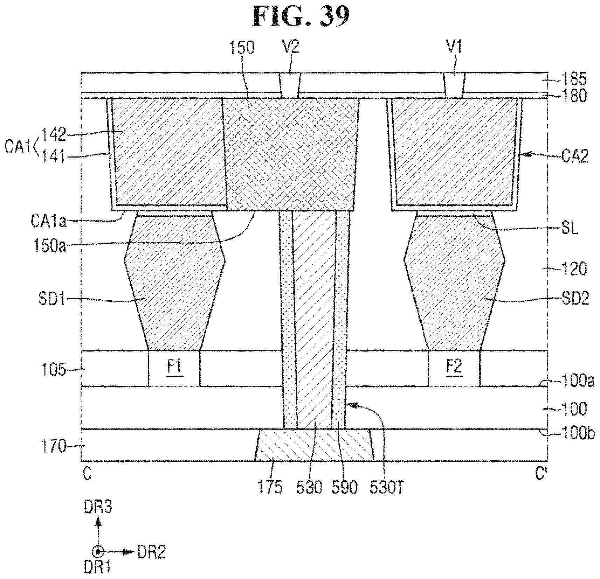

FIG. 37 is a layout view for describing a semiconductor device according to one or more exemplary embodiments of the present disclosure. FIG. 38 is a cross-sectional view taken along line D-D' of FIG. 37. FIG. 39 is a cross-sectional view taken along line E-E' of FIG. 37.

Referring to FIGS. 37 to 39, in a semiconductor device according to one or more exemplary embodiments of the present disclosure, a through via 530 may be formed in a hole type.

For example, each of a first gate electrode G51 and a second gate electrode G52 may extend in the second horizontal direction DR2 on the first active pattern F1, the second active pattern F2, and the field insulating layer 105. The second gate electrode G52 may be spaced apart from the first gate electrode G51 in the first horizontal direction DR1. The first gate electrode G51 may surround each of the first plurality of nanosheets NW1 and the third plurality of nanosheets NW3.

For example, a through via trench 530T may be formed between the first active pattern F1 and the second active pattern F2. The through via trench 530T may be spaced apart from each of the first active pattern F1 and the second active pattern F2 in the second horizontal direction DR2. The through via trench 530T may be formed between the first source/drain contact CA1 and the second source/drain contact CA2. The through via trench 530T may be spaced apart from each of the first source/drain contact CA1 and the second source/drain contact CA2 in the second horizontal direction DR2. The through via trench 530T may be formed between the first gate electrode G51 and the second gate electrode G52. The through via trench 530T may be spaced apart from each of the first gate electrode G51 and the second gate electrode G52 in the first horizontal direction DR1.

The through via trench 530T may extend from the lower surface 100b of the substrate 100 to the lower surface 150a of the connection portion 150 in the vertical direction DR3. That is, the through via trench 530T may penetrate through the substrate 100, the field insulating layer 105, and the first upper interlayer insulating layer 120 in the vertical direction DR3. For example, a width of the through via trench 530T in the second horizontal direction DR2 may decrease as it is closer to the lower surface 100b of the substrate 100. For example, a bottom surface of the through via trench 530T may be formed on the same plane as the lower surface 100b of the substrate 100.

A through via insulating layer 590 may be disposed along sidewalls of the through via trench 530T. For example, the through via insulating layer 590 may be conformally formed. For example, the through via insulating layer 590 may extend in the vertical direction DR3 from the lower surface 100b of the substrate 100 to the upper surface of the first upper interlayer insulating layer 120. For example, a lower surface of the through via insulating layer 590 may be formed on the same plane as the lower surface 100b of the substrate 100. The lower surface of the through via insulating layer 590 may be in contact with the lower wiring layer 175. An upper surface of the through via insulating layer 590 may be in contact with the lower surface 150a of the connection portion 150.

The through via insulating layer 590 may include an insulating material. The through via insulating layer 590 may include, for example, at least one of silicon nitride (SiN), silicon oxynitride (SiON), silicon oxide (SiO₂), silicon carbonitride (SiCN); silicon oxycarbonitride (SiOCN), silicon boron nitride (SiBN), silicon oxyboron nitride (SiOBN), silicon oxycarbide (SiOC), and a combination thereof.

The through via 530 may fill a space between the through via insulating layers 590 in the through via trench 530T. The through via 530 may extend from the lower surface 100b of the substrate 100 to the lower surface 150a of the connection portion 150 in the vertical direction DR3. That is, the through via 530 may penetrate through the substrate 100, the field insulating layer 105, and the first upper interlayer insulating layer 120 in the vertical direction DR3. For example, a lower surface of the through via 530 may be formed on the same plane as the lower surface 100b of the substrate 100. For example, the lower surface of the through via 530 may be in contact with the lower wiring layer 175. An upper surface of the through via 530 may be in contact with the lower surface 150a of the connection portion 150. The through via 530 may be insulated from the substrate 100 by the through via insulating layer 590.

A first gate contact CB51 may penetrate through the capping pattern 113 in the vertical direction DR3 and be connected to the first gate electrode G51. A second gate contact CB52 may penetrate through the capping pattern 113 in the vertical direction DR3 and be connected to the second gate electrode G52. Each of the first and second gate contacts CB51 and CB52 may include a second barrier layer 561 and a second filling layer 562. The second barrier layer 561 may form sidewalls and a bottom surface of each of the first and second gate contacts CB51 and CB52. The second filling layer 562 may fill a space between the second barrier layers 561 in each of the first and second gate contacts CB51 and CB52. For example, a third via V53 may penetrate through the second upper interlayer insulating layer 185 and the etch stop layer 180 in the vertical direction DR3 and be connected to the first gate contact CB51.

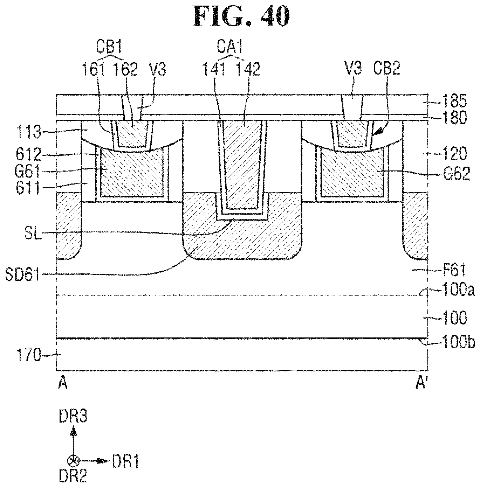

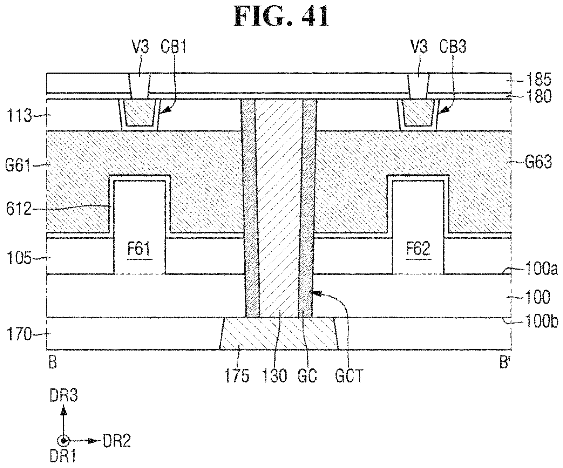

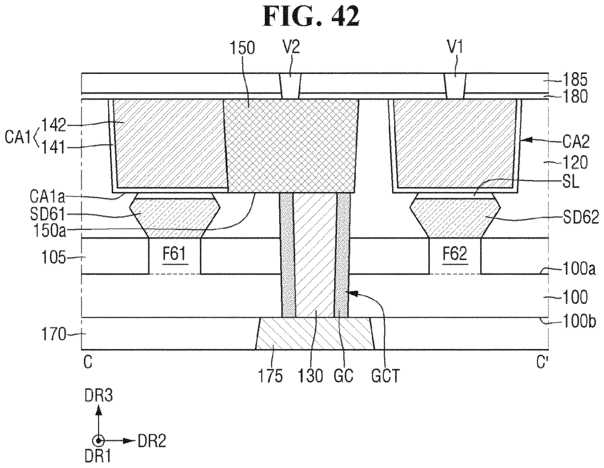

Hereinafter, a semiconductor device according to one or more exemplary embodiments of the present disclosure will be described with reference to FIGS. 40 to 42. Differences from the semiconductor device illustrated in FIGS. 1 to 4 will be mainly described.

FIGS. 40 to 42 are cross-sectional views for describing a semiconductor device according to one or more exemplary embodiments.

Referring to FIGS. 40 to 42, a semiconductor device according to one or more exemplary embodiments of the present disclosure may include a fin-type transistor (FinFET). For example, the semiconductor device according to one or more exemplary embodiments of the present disclosure may include a substrate 100, first and second active patterns F61 and F62, a field insulating layer 105, first to third gate electrodes G61, G62, and G63, a gate spacer 611, a gate insulating layer 612, a capping pattern 113, first and second source/drain regions SD61 and SD62, a first upper interlayer insulating layer 120, a gate cut GC, a through via 130, first and second source/drain contacts CA1 and CA2, a silicide layer SL, a connection portion 150, first to third gate contacts CB1, CB2, and CB3, a lower interlayer insulating layer 170, a lower wiring layer 175, an etch stop layer 180, a second upper interlayer insulating layer 185, and first to third vias V1, V2, and V3. Hereinafter, descriptions of the components described with reference to FIGS. 1 to 4 will be omitted.

Each of the first and second active patterns F61 and F62 may extend in the first horizontal direction DR1 on the upper surface 100a of the substrate 100. The second active pattern F62 may be spaced apart from the first active pattern F61 in the second horizontal direction DR2. The first gate electrode G61 may extend in the second horizontal direction DR2 on the first active pattern F61 and the field insulating layer 105. The second gate electrode G62 may extend in the second horizontal direction DR2 on the first active pattern F61 and the field insulating layer 105. The second gate electrode G62 may be spaced apart from the first gate electrode G61 in the first horizontal direction DR1. The third gate electrode G63 may extend in the second horizontal direction DR2 on the second active pattern F62 and the field insulating layer 105. The third gate electrode G63 may be spaced apart from the first gate electrode G61 in the second horizontal direction DR2.

The gate spacer 611 may extend in the second horizontal direction DR2 along both sidewalls of the first gate electrode G61 on the first active pattern F61 and the field insulating layer 105. The gate spacer 611 may extend in the second horizontal direction DR2 along both sidewalls of the second gate electrode G62 on the first active pattern F61 and the field insulating layer 105. The gate insulating layer 612 may be disposed between the first gate electrode G61 and the first active pattern F61. The gate insulating layer 612 may be disposed between the second gate electrode G62 and the first active pattern F61. The gate insulating layer 612 may be disposed between the third gate electrode G63 and the second active pattern F62. The gate insulating layer 612 may be disposed between each of the first to third gate electrodes G61, G62, and G63 and the field insulating layer 105. The gate insulating layer 612 may be disposed between each of the first and second gate electrodes G61 and G62 and the gate spacer 611. The first source/drain region SD61 may be disposed on both sides of each of the first gate electrode G61 and the second gate electrode G62 on the first active pattern F61. The second source/drain region SD62 may be disposed on the second active pattern F62.

The exemplary embodiments of the present disclosure have been described hereinabove with reference to the accompanying drawings, but the present disclosure is not limited to the above-described exemplary embodiments, and may be implemented in various different forms, and one of ordinary skill in the art to which the present disclosure pertains may understand that the present disclosure may be implemented in other specific forms without changing the technical spirit or essential features of the present disclosure. Therefore, it should be understood that the exemplary embodiments described above are illustrative in all aspects and not restrictive.

## Claims

1. A semiconductor device comprising:
a substrate;
an active pattern extending in a first horizontal direction on an upper surface of the substrate;
a field insulating layer surrounding a sidewall of the active pattern on the upper surface of the substrate;
a first gate electrode extending in a second horizontal direction intersecting the first horizontal direction on the active pattern;
a source/drain region disposed on at least one side of the first gate electrode on the active pattern;
an upper interlayer insulating layer covering the source/drain region on the field insulating layer;
a through via penetrating through the substrate, the field insulating layer and the upper interlayer insulating layer in a vertical direction, the through via spaced apart from the source/drain region in the second horizontal direction;
a source/drain contact disposed inside the upper interlayer insulating layer on at least one side of the first gate electrode, the source/drain contact connected to the source/drain region; and
a connection portion disposed inside the upper interlayer insulating layer, the connection portion connected to each of the through via and the source/drain contact,
wherein a width of the connection portion in the first horizontal direction is greater than a width of the source/drain contact in the first horizontal direction.

2. The semiconductor device of claim 1, wherein an upper surface of the source/drain contact, an upper surface of the connection portion, and an uppermost surface of the through via are each formed on a first plane.

3. The semiconductor device of claim 1, wherein the source/drain contact comprises a barrier layer forming sidewalls and a bottom surface of the source/drain contact and a filling layer filling a space between the sidewalls and the bottom surface formed by the barrier layer, and
wherein sidewalls of the connection portion are in contact with each of the barrier layer and the filling layer.

4. The semiconductor device of claim 1,
wherein a lower surface of the substrate defines a second plane, and
wherein a lower surface of the through via is formed on the second plane.

5. The semiconductor device of claim 1,
wherein the through via comprises sidewalls, and
wherein the semiconductor device further comprises:
a second gate electrode spaced apart from the first gate electrode in the second horizontal direction; and
a gate cut penetrating through the substrate, the field insulating layer and the upper interlayer insulating layer in the vertical direction, the gate cut being in contact with the sidewalls of the through via in the second horizontal direction, the gate cut separating the first gate electrode and the second gate electrode from each other.

6. The semiconductor device of claim 5,
wherein a lower surface of the substrate defines a second plane, and
wherein a lower surface of the gate cut is formed on the second plane as a lower surface of the substrate.

7. The semiconductor device of claim 1, wherein the connection portion is formed as a single film.

8. The semiconductor device of claim 7, wherein the connection portion comprises a material different from each of the source/drain contact and the through via.

9. The semiconductor device of claim 1, wherein the connection portion comprises a connection portion barrier layer forming sidewalls and a bottom surface of the connection portion and a connection portion filling layer filling a space between the sidewalls and the bottom surface formed by the connection portion barrier layer,
wherein the connection portion barrier layer is in contact with each of the source/drain contact and the through via, and
wherein the connection portion filling layer is not in contact with each of the source/drain contact and the through via.

10. The semiconductor device of claim 1,
wherein a lower surface of the source/drain contact defines a third plane, and
wherein a lower surface of the connection portion is formed on the third plane.

11. The semiconductor device of claim 1, further comprising a plurality of nanosheets stacked and spaced apart from each other in the vertical direction on the active pattern, the plurality of nanosheets surrounded by the first gate electrode.

12. The semiconductor device of claim 1, further comprising:
a through via trench penetrating through the substrate, the field insulating layer, and the upper interlayer insulating layer in the vertical direction, the through via trench spaced apart from the first gate electrode in the first horizontal direction and spaced apart from the active pattern in the second horizontal direction; and
a through via insulating layer disposed along sidewalls of the through via trench,
wherein the through via fills a space between the through via insulating layer disposed along the sidewalls of the through via trench.

13. The semiconductor device of claim 1, wherein at least a portion of the through via overlaps the first gate electrode in the second horizontal direction.

14. The semiconductor device of claim 1, further comprising:
a lower interlayer insulating layer disposed on the lower surface of the substrate; and
a lower wiring layer disposed inside the lower interlayer insulating layer, the lower wiring layer connected to the through via.

15. The semiconductor device of claim 1, wherein a distance between a lower surface of the connection portion and an upper surface of the source/drain contact is less than a distance between a lower surface of the source/drain contact and the upper surface of the source/drain contact.
